# EUROPEAN PATENT APPLICATION

(11) **EP 4 797 912 A1**
(43) Date of publication of application: **26.08.2026**
(21) Application number: 24879688.0
(22) Date of filing: 15.10.2024
(51) Int. Cl.: H10F 39/18, H04N 25/70

(54) **LIGHT DETECTION DEVICE AND SOLID-STATE IMAGING DEVICE**

(30) Priority: 19.10.2023 JP 2023180648
(71) Applicant: Sony Semiconductor Solutions Corporation, Atsugi-shi, Kanagawa 243-0014 (JP)
(72) Inventor: YOSHIDA, Shinichi, Atsugi-shi, Kanagawa 243-0014 (JP); ANDO, Yukihiro, Atsugi-shi, Kanagawa 243-0014 (JP); IMAI, Shinichi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/036582
(87) International publication number: WO 2025/084263

(57) **Abstract**

A light detecting device according to an embodiment of the present disclosure includes a first semiconductor layer, a floating diffusion layer, a first transistor, and a first wiring. The first semiconductor layer has a first surface and a second surface opposed to each other, and includes a photoelectric converter buried in each pixel. The floating diffusion layer is buried in the first surface of the first semiconductor layer, has an upper surface flush with the first surface or protruding from the first surface, and accumulates signal charges generated at the photoelectric converter. The first transistor is provided on the first surface of the first semiconductor layer, and reads the signal charges from the floating diffusion layer. The first wiring includes polysilicon, and is coupled to the upper surface of the floating diffusion layer.

## Description

### Technical Field

The present disclosure relates to a light detecting device and a solid-state imaging device.

### Background Art

Patent Literature 1, for example, discloses an imaging device in which the area of a semiconductor region of a charge holding part is reduced by coupling a buried electrode provided on a separation part on a boundary between pixels on a first semiconductor substrate to the charge holding part provided on the first semiconductor substrate.

### Citation List

### Patent Literature

Patent Literature 1: International Publication No. WO 2022/138914

### Summary of the Invention

Meanwhile, it is desired for a light detecting device used as an imaging device or the like to have improved reliability upon miniaturization of pixels.

It is desirable to provide a light detecting device and a solid-state imaging device each making it possible to have improved reliability.

A light detecting device according to an embodiment of the present disclosure includes a first semiconductor layer, a floating diffusion layer, a first transistor, and a first wiring. The first semiconductor layer has a first surface and a second surface opposed to each other, and includes a photoelectric converter buried in each pixel. The floating diffusion layer is buried in the first surface of the first semiconductor layer, has an upper surface flush with the first surface or protruding from the first surface, and accumulates signal charges generated at the photoelectric converter. The first transistor is provided on the first surface of the first semiconductor layer, and reads the signal charges from the floating diffusion layer. The first wiring includes polysilicon, and is coupled to the upper surface of the floating diffusion layer.

A solid-state imaging device according to an embodiment of the present disclosure includes an optical system, a light detecting device, and a signal processing circuit that calculates a distance to a measurement target from an output signal of the light detecting device. The light detecting device includes the light detecting device according to the above-described embodiment.

According to the light detecting device and the solid-state imaging device of an embodiment of the present disclosure, the floating diffusion layer is buried in the first surface of the first semiconductor layer and has an upper surface flushed with the first surface or protruding from the first surface. Further, the first wiring including polysilicon and directly coupled to the upper surface of the floating diffusion layer is provided. It is therefore possible to mitigate an electric field between the floating diffusion layer and the first transistor.

### Brief Description of the Drawings

[FIG. 1] FIG. 1 is a block diagram illustrating an exemplary functional configuration of an imaging device according to a first embodiment of the present disclosure.
[FIG. 2] FIG. 2 is a schematic plan view illustrating an outline configuration of the imaging device illustrated in FIG. 1.
[FIG. 3] FIG. 3 is a schematic view illustrating cross-sectional configuration taken along a line A-A' of FIG. 2.
[FIG. 4] FIG. 4 is an exemplary equivalent circuit diagram of a pixel sharing unit illustrated in FIG. 1.
[FIG. 5] FIG. 5 is a schematic cross-sectional view illustrating a specific exemplary configuration of the imaging device illustrated in FIG. 3.
[FIG. 6] FIG. 6 is a schematic plan view illustrating an exemplary layout of the pixel sharing unit on a first substrate.
[FIG. 7] FIG. 7 is a schematic view illustrating an exemplary cross-sectional configuration taken along a line I-I' illustrated in FIG. 6.
[FIG. 8] FIG. 8 is a schematic view illustrating another exemplary cross-sectional configuration taken along the line I-I' illustrated in FIG. 6.
[FIG. 9] FIG. 9 is an impurity concentration profile from a through-electrode to a gate of a transfer transistor illustrated in FIG. 7 and other drawings.
[FIG. 10A] FIG. 10A is a schematic cross-sectional view illustrating an exemplary step of manufacturing a FD having the impurity concentration profile illustrated in FIG. 9 and the vicinity thereof.
[FIG. 10B] FIG. 10B is a schematic cross-sectional view illustrating a step following FIG. 10A.
[FIG. 10C] FIG. 10C is a schematic cross-sectional view illustrating a step following FIG. 10B.
[FIG. 10D] FIG. 10D is a schematic cross-sectional view illustrating a step following FIG. 10C.
[FIG. 10E] FIG. 10E is a schematic cross-sectional view illustrating a step following FIG. 10D.
[FIG. 10F] FIG. 10F is a schematic cross-sectional view illustrating a step following FIG. 10E.
[FIG. 10G] FIG. 10G is a schematic cross-sectional view illustrating a step following FIG. 10F.
[FIG. 10H] FIG. 10H is a schematic cross-sectional view illustrating a step following FIG. 10G.
[FIG. 11] FIG. 11 is a schematic view illustrating a path of an input signal or the like to the imaging device illustrated in FIG. 3.
[FIG. 12] FIG. 12 is a schematic view illustrating a signal path of a pixel signal of the imaging device illustrated in FIG. 3.
[FIG. 13] FIG. 13 is another exemplary equivalent circuit diagram of a pixel sharing unit according to Modification Example 1 of the present disclosure.
[FIG. 14] FIG. 14 is a schematic plan view illustrating an exemplary layout of the pixel sharing unit on the first substrate corresponding to the equivalent circuit diagram illustrated in FIG. 13.
[FIG. 15] FIG. 15 is a schematic view illustrating an exemplary cross-sectional configuration taken along a line II-II' illustrated in FIG. 14.
[FIG. 16] FIG. 16 is a block diagram illustrating an exemplary configuration of an electronic device including the imaging device illustrated in FIG. 1.
[FIG. 17A] FIG. 17A is a schematic diagram illustrating an exemplary overall configuration of a light detecting system including the imaging device illustrated in FIG. 1 and other drawings.
[FIG. 17B] FIG. 17B is a diagram illustrating an exemplary circuit configuration of the light detecting system illustrated in FIG. 17A.
[FIG. 18] FIG. 18 is a view depicting an example of a schematic configuration of an endoscopic surgery system.
[FIG. 19] FIG. 19 is a block diagram depicting an example of a functional configuration of a camera head and a camera control unit (CCU).
[FIG. 20] FIG. 20 is a block diagram depicting an example of schematic configuration of a vehicle control system.
[FIG. 21] FIG. 21 is a diagram of assistance in explaining an example of installation positions of an outside-vehicle information detecting section and an imaging section.
[FIG. 22] FIG. 22 is a schematic view illustrating an exemplary cross-sectional configuration of an imaging device according to a second embodiment of the present disclosure.
[FIG. 23] FIG. 23 is a schematic view illustrating an exemplary planar configuration of a pixel sharing unit of the imaging device illustrated in FIG. 22.
[FIG. 24] FIG. 24 is an exemplary equivalent circuit diagram of the pixel sharing unit illustrated in FIG. 23.
[FIG. 25A] FIG. 25A is a schematic cross-sectional view illustrating an exemplary step of manufacturing the imaging device illustrated in FIG. 22.
[FIG. 25B] FIG. 25B is a schematic cross-sectional view illustrating a step following FIG. 25A.
[FIG. 25C] FIG. 25C is a schematic cross-sectional view illustrating a step following FIG. 25B.
[FIG. 25D] FIG. 25D is a schematic cross-sectional view illustrating a step following FIG. 25C.
[FIG. 25E] FIG. 25E is a schematic cross-sectional view illustrating a step following FIG. 25D.
[FIG. 25F] FIG. 25F is a schematic cross-sectional view illustrating a step following FIG. 25E.
[FIG. 26] FIG. 26 is a schematic view illustrating an exemplary cross-sectional configuration of an imaging device according to Modification Example 2 of the present disclosure.
[FIG. 27] FIG. 27 is a schematic view illustrating an exemplary cross-sectional configuration of an imaging device according to Modification Example 3 of the present disclosure.
[FIG. 28] FIG. 28 is a schematic view illustrating an exemplary cross-sectional configuration of an imaging device according to Modification Example 4 of the present disclosure.
[FIG. 29] FIG. 29 is a schematic view illustrating an exemplary cross-sectional configuration of an imaging device according to Modification Example 5 of the present disclosure.
[FIG. 30] FIG. 30 is a schematic view illustrating an exemplary planar configuration of a pixel sharing unit of the imaging device illustrated in FIG. 29.
[FIG. 31] FIG. 31 is a schematic view illustrating an exemplary cross-sectional configuration of an imaging device according to Modification Example 6 of the present disclosure.
[FIG. 32] FIG. 32 is a schematic view illustrating an exemplary planar configuration of a pixel sharing unit of the imaging device illustrated in FIG. 31.
[FIG. 33A] FIG. 33A is a schematic cross-sectional view illustrating an exemplary step of manufacturing the imaging device illustrated in FIG. 31.
[FIG. 33B] FIG. 33B is a schematic cross-sectional view illustrating a step following FIG. 33A.
[FIG. 33C] FIG. 33C is a schematic cross-sectional view illustrating a step following FIG. 33B.
[FIG. 33D] FIG. 33D is a schematic cross-sectional view illustrating a step following FIG. 33C.
[FIG. 33E] FIG. 33E is a schematic cross-sectional view illustrating a step following FIG. 33D.
[FIG. 34] FIG. 34 is a schematic view illustrating an exemplary cross-sectional configuration of an imaging device according to a third embodiment of the present disclosure.
[FIG. 35] FIG. 35 is a schematic view illustrating an exemplary planar configuration of a pixel sharing unit of the imaging device illustrated in FIG. 34.
[FIG. 36] FIG. 36 is a schematic view illustrating another exemplary cross-sectional configuration of the imaging device according to the third embodiment of the present disclosure.
[FIG. 37] FIG. 37 is an impurity concentration profile from a through-electrode to a gate of a transfer transistor illustrated in FIG. 34 and other drawings.
[FIG. 38A] FIG. 38A is a schematic cross-sectional view illustrating an exemplary step of manufacturing the imaging device illustrated in FIG. 36.
[FIG. 38B] FIG. 38B is a schematic cross-sectional view illustrating a step following FIG. 38A.
[FIG. 38C] FIG. 38C is a schematic cross-sectional view illustrating a step following FIG. 38B.
[FIG. 38D] FIG. 38D is a schematic cross-sectional view illustrating a step following FIG. 38C.
[FIG. 38E] FIG. 38E is a schematic cross-sectional view illustrating a step following FIG. 38D.
[FIG. 38F] FIG. 38F is a schematic cross-sectional view illustrating a step following FIG. 38E.
[FIG. 38G] FIG. 38G is a schematic cross-sectional view illustrating a step following FIG. 38F.
[FIG. 38H] FIG. 38H is a schematic cross-sectional view illustrating a step following FIG. 38G.
[FIG. 38I] FIG. 38I is a schematic cross-sectional view illustrating a step following FIG. 38H.
[FIG. 39] FIG. 39 is a schematic view illustrating an exemplary cross-sectional configuration of an imaging device according to Modification Example 7 of the present disclosure.
[FIG. 40] FIG. 40 is a schematic view illustrating an exemplary planar configuration of a pixel sharing unit of the imaging device illustrated in FIG. 39.

### Modes for Carrying Out the Invention

In the following, some embodiments of the present disclosure are described in detail with reference to the drawings. The following description is one specific example of the present disclosure, and the present disclosure is not limited to the embodiments described below. Further, the present disclosure is not limited to the embodiments described below in terms of arrangements, dimensions, dimension ratios, and the like of constituent elements illustrated in each of the drawings. It is to be noted that the description will be given in the following order.
1. First Embodiment (An example of an imaging device in which a floating diffusion is buried in a semiconductor layer, and a wiring including polysilicon is directly coupled to an upper surface of the floating diffusion)
2. Modification Example 1 (Another example of the imaging device)
3. Second Embodiment (An example of an imaging device in which the floating diffusion and a source of a reset transistor protrude from a surrounding semiconductor layer)
4. Modification Examples
   4-1. Modification Example 2 (Another Example of Imaging Device)
   4-2. Modification Example 3 (Another Example of Imaging Device)
   4-3. Modification Example 4 (Another Example of Imaging Device)
   4-4. Modification Example 5 (Another Example of Imaging Device)
   4-5. Modification Example 6 (Another Example of Imaging Device)
5. Third Embodiment (An example of an imaging device in which the floating diffusion has a gap in which a through-electrode is buried)
6. Modification Example 7 (Another Example of Imaging Device)
7. Application Example
8. Practical Example

### <1. Embodiments>

### [Functional Configuration of Imaging Device]

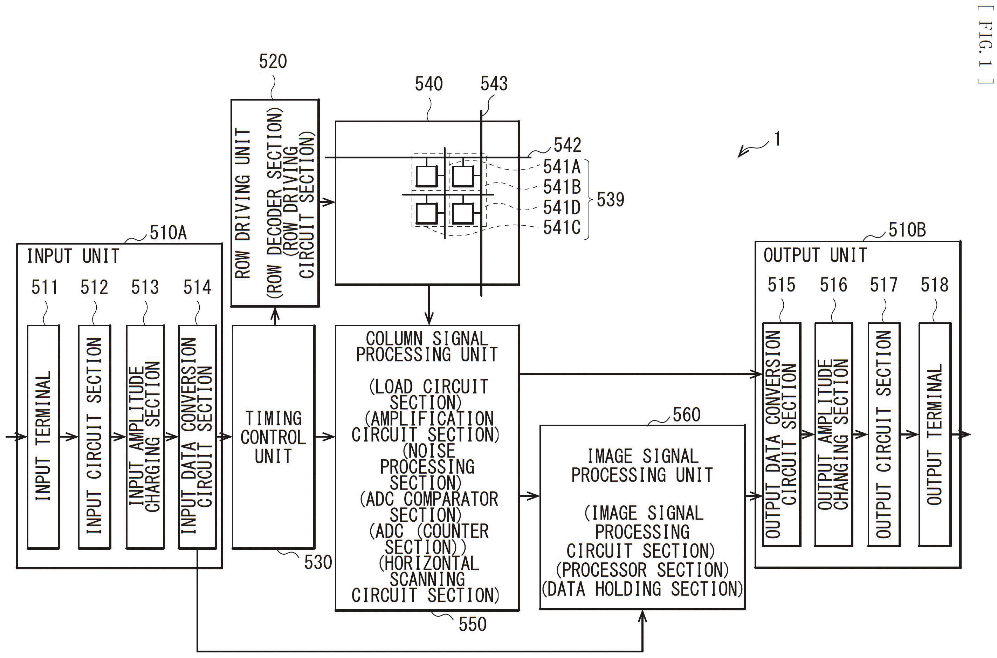

FIG. 1 is a block diagram illustrating an exemplary functional configuration of a light detecting device (imaging device 1) according to a first embodiment of the present disclosure.

The imaging device 1 of FIG. 1 includes, for example, an input unit 510A, a row driving unit 520, a timing control unit 530, a pixel array unit 540, a column signal processing unit 550, an image signal processing unit 560, and an output unit 510B.

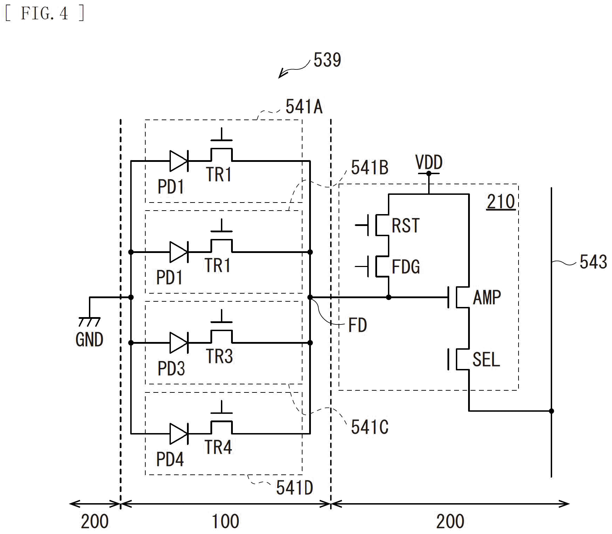

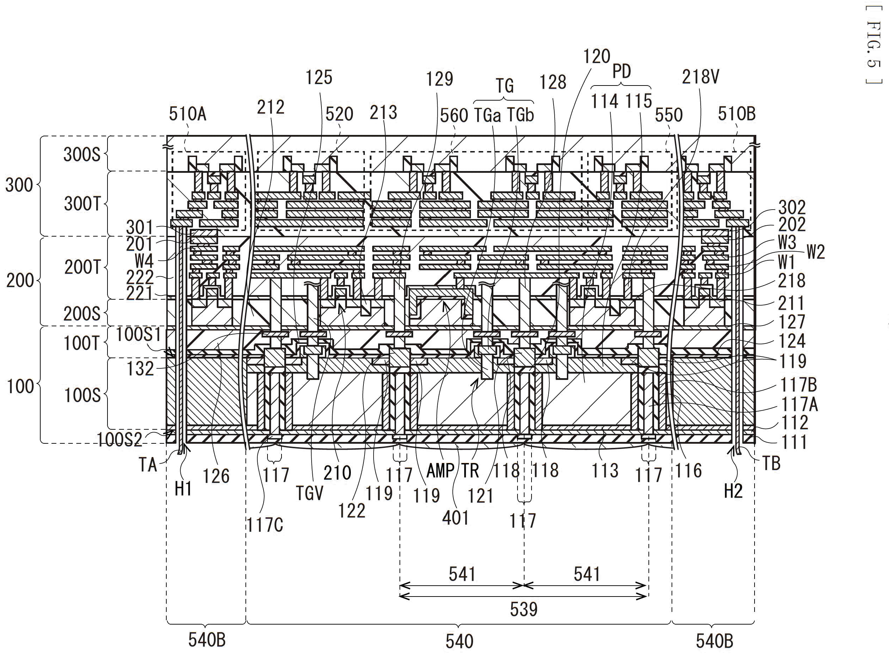

In the pixel array unit 540, pixels 541 are arranged in repeated arrays. More specifically, pixel sharing units 539 each including a plurality of pixels are arranged in repeated arrays in a row direction and a column direction, for example. It is to be noted that, herein, the row direction is referred to as an H-direction, and the column direction orthogonal to the row direction is referred to as a V-direction, in some cases, for convenience. In the example of FIG. 1, each pixel sharing unit 539 includes four pixels (pixels 541A, 541B, 541C, and 541D). The pixels 541A, 541B, 541C, and 541D each include a photodiode PD (illustrated in FIG. 5 to be described later). The pixel sharing unit 539 is a unit that shares a single pixel circuit (a pixel circuit 210 of FIG. 4 to be described later). In other words, one pixel circuit (the pixel circuit 210 to be described later) is included for each four pixels (the pixels 541A, 541B, 541C, and 541D), for example. An image signal is sequentially read from each of the pixels 541A, 541B, 541C, and 541D by operating the pixel circuit in a time-divisional manner. The pixels 541A, 541B, 541C, and 541D are arranged in two rows and two columns, for example. In the pixel array unit 540, a plurality of row driving signal lines 542 and a plurality of vertical signal lines (column reading lines) 543 are provided as well as the pixels 541A, 541B, 541C, and 541D. The row driving signal lines 542 drive the pixels 541 included in the pixel sharing units 539 arranged in the row direction in the pixel array unit 540. The row driving signal lines 542 drive the pixels arranged in the row direction in the pixel sharing unit 539. As described in detail below with reference to FIG. 4, multiple transistors are provided in the pixel sharing unit 539. To drive each of the multiple transistors, the plurality of row driving signal lines 542 is coupled to each pixel sharing unit 539. The pixel sharing unit 539 is coupled to the vertical signal line (column reading line) 543. A pixel signal is read from each of the pixels 541A, 541B. 541C, and 541D of the pixel sharing unit 539 via the vertical signal line (column reading line) 543.

The row driving unit 520 includes, for example, a row address control section that determines a position of a row including pixels to be driven. In other words, the row driving unit 520 includes a row decoder section, and a row driving circuit section that generates signals to drive the pixels 541A, 541B, 541C, and 541D.

The column signal processing unit 550 includes, for example, a load circuit section that is coupled to the vertical signal lines 543 to form a source follower circuit together with the pixels 541A, 541B, 541C, and 541D (the pixel sharing unit 539). The column signal processing unit 550 may include an amplification circuit section that amplifies the signal read from the pixel sharing unit 539 via the vertical signal lines 543. The column signal processing unit 550 may include a noise processing section. The noise processing section removes a noise level of the system from the signal read from the pixel sharing unit 539 as a result of photoelectric conversion, for example.

The column signal processing unit 550 includes, for example, an analog digital converter (ADC). The analog digital converter converts the signal read from the pixel sharing unit 539 or the analog signal having undergone the noise processing into a digital signal. The ADC includes, for example, a comparator section and a counter section. The comparator section compares the analog signal that is a conversion target with a reference signal that is a comparison target. The counter section measures time until inversion of a result of the comparison at the comparator section. The column signal processing unit 550 may include a horizontal scanning circuit section that performs control that scans a column to be read.

The timing control unit 530 supplies a signal that controls a timing to the row driving unit 520 and the column signal processing unit 550, based on a reference clock signal or a timing control signal received by the device.

The image signal processing unit 560 is a circuit that performs various kinds of signal processing on the data obtained as a result of the photoelectric conversion, that is, the data obtained as a result of an imaging operation of the imaging device 1. The image signal processing unit 560 includes, for example, an image signal processing circuit section and a data holding section. The image signal processing unit 560 may include a processor section.

An example of the signal processing to be performed by the image signal processing unit 560 is tone curve correction processing that increases a tone scale when imaging data obtained as a result of the AD conversion is imaging data on a dark subject, and decreases the tone scale when the imaging data is imaging data on a bright subject. In this case, it is desirable that characteristic data on the tone curve as to what tone curve is used to correct the tone scale of the imaging data be stored in advance in the data holding section of the image signal processing unit 560.

The input unit 510A is used to input the reference clock signal, the timing control signal, and the characteristic data described above from the outside of the device to the imaging device 1, for example. The timing control signal is, for example, a vertical synchronization signal, a horizontal synchronization signal, or the like. The characteristic data is recorded in, for example, the data holding section of the image signal processing unit 560. The input unit 510A includes, for example, an input terminal 511, an input circuit section 512, an input amplitude changing section 513, an input data conversion circuit section 514, and a power supply section (not illustrated).

The input terminal 511 is an external terminal to which data is inputted. The input circuit section 512 incorporates the signal inputted to the input terminal 511 into the imaging device 1. In the input amplitude changing section 513, an amplitude of the signal incorporated by the input circuit section 512 is changed to an amplitude easy to use inside the imaging device 1. In the input data conversion circuit section 514, an arrangement of data columns of the input data is changed. The input data conversion circuit section 514 is, for example, a serial-parallel conversion circuit. In the serial-parallel conversion circuit, a serial signal received as input data is converted into a parallel signal. It is to be noted that, in the input unit 510A, the input amplitude changing section 513 and the input data conversion circuit section 514 may be omitted. The power supply section supplies electric power set at various voltages to be necessary inside the imaging device 1, from electric power supplied from the outside to the imaging device 1.

In a case where the imaging device 1 is coupled to an external memory device, a memory interface circuit provided in the input unit 510A may receive data from the external memory device. The external memory device is, for example, a flash memory, a SRAM, a DRAM, or the like.

The output unit 510B outputs image data to outside the device. The image data is, for example, data on an image captured by the imaging device 1, data on an image having undergone the signal processing at the image signal processing unit 560, or the like. The output unit 510B includes, for example, an output data conversion circuit section 515, an output amplitude changing section 516, an output circuit section 517, and an output terminal 518.

The output data conversion circuit section 515 is, for example, a parallel-serial conversion circuit. In the output data conversion circuit section 515, a parallel signal used inside the imaging device 1 is converted into a serial signal. The output amplitude changing section 516 changes the amplitude of the signal used inside the imaging device 1. The signal having been changed in amplitude is easy to be used in an external device coupled to the outside of the imaging device 1. The output circuit section 517 is a circuit that outputs data from inside the imaging device 1 to outside the device. The output circuit section 517 drives a wiring provided outside the imaging device 1 and coupled to the output terminal 518. Data is outputted from the imaging device 1 to outside the device through the output terminal 518. In the output unit 510B, the output data conversion circuit section 515 and the output amplitude changing section 516 may be omitted.

In a case where the imaging device 1 is coupled to an external memory device, a memory interface circuit provided in the output unit 510B may output data to the external memory device. The external memory device is, for example, a flash memory, a SRAM, a DRAM, or the like.

### [Outline Configuration of Imaging Device]

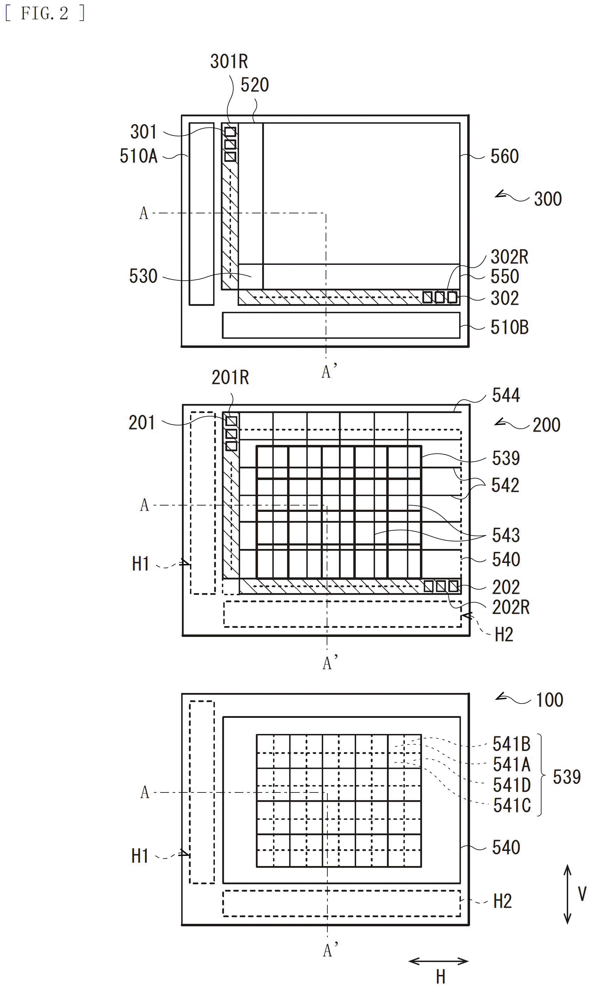

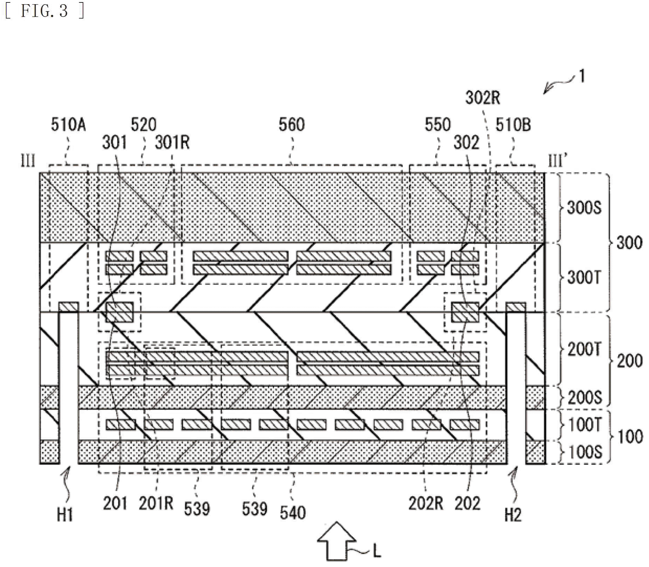

FIGs. 2 and 3 illustrate an exemplary outline configuration of the imaging device 1. The imaging device 1 includes three substrates (a first substrate 100, a second substrate 200, and a third substrate 300). FIG. 2 schematically illustrates respective planar configurations of the first substrate 100, the second substrate 200, and the third substrate 300. FIG. 3 schematically illustrates a cross-sectional configuration of the first substrate 100, the second substrate 200, and the third substrate 300 stacked on each other. FIG. 3 corresponds to a cross-sectional configuration taken along a line A-A' indicated in FIG. 2. The imaging device 1 is an imaging device having a three-dimensional structure in which the three substrates (the first substrate 100, the second substrate 200, and the third substrate 300) are bonded to each other. The first substrate 100 includes a semiconductor layer 100S and a wiring layer 100T. The second substrate 200 includes a semiconductor layer 200S and a wiring layer 200T. The third substrate 300 includes a semiconductor layer 300S and a wiring layer 300T. Here, a combination of a wiring included in each of the first substrate 100, the second substrate 200, and the third substrate 300, and an interlayer insulating film provided around the wiring is referred to as a wiring layer (100T, 200T, and 300T) of each substrate (the first substrate 100, the second substrate 200, and the third substrate 300) for convenience. The first substrate 100, the second substrate 200, and the third substrate 300 are stacked in this order, and along this stacking direction, the semiconductor layer 100S, the wiring layer 100T, the semiconductor layer 200S, the wiring layer 200T, the wiring layer 300T, and the semiconductor layer 300S are arranged in this order. Specific configurations of the first substrate 100, the second substrate 200, and the third substrate 300 will be described later. An arrow in FIG. 3 represents an incident direction of light L toward the imaging device 1. Herein, in the following cross-sectional views, a light-incident side of the imaging device 1 is referred to as "down", "lower side", or "below", and another side opposite to the light-incident side is referred to as "up", "upper side", or "above", in some cases, for convenience. Further, herein, as for the substrate including the semiconductor layer and the wiring layer, a side close to the wiring layer is referred to as a front surface, and a side close to the semiconductor layer is referred to as a rear surface, in some cases, for convenience. It is to be noted that the components described herein are not limited to the names described above. The imaging device 1 is, for example, a rear-surface irradiation light detecting device that receives incident light through the rear surface of the first substrate 100 including a photodiode.

Both of the pixel array unit 540 and the pixel sharing unit 539 included in the pixel array unit 540 are configured by both of the first substrate 100 and the second substrate 200. On the first substrate 100, the multiple pixels 541A, 541B, 541C, and 541D of the pixel sharing unit 539 are provided. Each of these pixels 541 includes the photodiode (the photodiode PD described below) and a transfer transistor (a transfer transistor TR described below). On the second substrate 200, the pixel circuit (the pixel circuit 210 described below) of the pixel sharing unit 539 is provided. The pixel circuit reads a pixel signal transferred from the photodiode of each of the pixels 541A, 541B, 541C, and 541D via the transfer transistor, or resets the photodiode. The second substrate 200 includes, in addition to the pixel circuit, the plurality of row driving signal lines 542 extending in the row direction and the plurality of vertical signal lines 543 extending in the column direction. The second substrate 200 further includes a power line 544 (a power line VDD or the like described below) extending in the row direction. The third substrate 300 includes, for example, the input unit 510A, the row driving unit 520, the timing control unit 530, the column signal processing unit 550, the image signal processing unit 560, and the output unit 510B. For example, in the direction in which the first substrate 100, the second substrate 200, and the third substrate 300 are stacked (hereinafter simply referred to as "stacking direction"), a part of the row driving unit 520 is provided in a region overlapping the pixel array unit 540. More specifically, the row driving unit 520 is provided in a region overlapping the vicinity of an H-direction end of the pixel array unit 540 in the stacking direction (FIG. 2). For example, in the stacking direction, a part of the column signal processing unit 550 is provided in a region overlapping the pixel array unit 540. More specifically, the column signal processing unit 550 is provided in a region overlapping the vicinity of a V-direction end of the pixel array unit 540 in the stacking direction (FIG. 2). Although not illustrated in the drawings, the input unit 510A and the output unit 510B may be arranged on the other substrate, such as the second substrate 200, other than the third substrate 300, for example. Alternatively, the input unit 510A and the output unit 510B may be provided on the rear surface (light-incident surface) of the first substrate 100. It is to be noted that the pixel circuit provided on the second substrate 200 is also referred to as a pixel transistor circuit, a pixel transistor group, a pixel transistor, a pixel reading circuit, or a read-out circuit, in some cases. Herein, the name "pixel circuit" is employed.

The first substrate 100 and the second substrate 200 are electrically coupled to each other via through-electrodes (through-electrodes 128 and 129 of FIG. 5 described below), for example. The second substrate 200 and the third substrate 300 are electrically coupled to each other via contact units 201, 202, 301, and 302, for example. The contact units 201 and 202 are provided on the second substrate 200, and the contact units 301 and 302 are provided on the third substrate 300. The contact unit 201 of the second substrate 200 is in contact with the contact unit 301 of the third substrate 300, and the contact unit 202 of the second substrate 200 is in contact with the contact unit 302 of the third substrate 300. The second substrate 200 includes a contact region 201R in which multiple contact units 201 are provided, and a contact region 202R in which multiple contact units 202 are provided. The third substrate 300 includes a contact region 301R in which multiple contact units 301 are provided, and a contact region 302R in which multiple contact units 302 are provided. The contact regions 201R and 301R are provided between the pixel array unit 540 and the row driving unit 520 in the stacking direction (FIG. 3). In other words, the contact regions 201R and 301R are provided in a region where the row driving unit 520 (the third substrate 300) and the pixel array unit 540 (the second substrate 200) overlap each other in the stacking direction, or in the vicinity thereof, for example. The contact regions 201R and 301R are provided on an H-direction end of this region, for example (FIG. 2). On the third substrate 300, the contact region 301R is provided on a part of the row driving unit 520, specifically, at a position overlapping an H-direction end of the row driving unit 520, for example (FIGs. 2 and 3). The contact units 201 and 301 couple the row driving unit 520 provided on the third substrate 300 and the row driving signal line 542 provided on the second substrate 200, for example. The contact units 201 and 301 may couple the input unit 510A provided on the third substrate 300, a power line 544, and a reference potential line (a reference potential line VSS described below), for example. The contact regions 202R and 302R are provided between the pixel array unit 540 and the column signal processing unit 550 in the stacking direction. In other words, the contact regions 202R and 302R are provided in a region where the column signal processing unit 550 (the third substrate 300) and the pixel array unit 540 (the second substrate 200) overlap each other in the stacking direction, or in the vicinity thereof, for example. The contact regions 202R and 302R are provided on a V-direction end of this region, for example. On the third substrate 300, the contact region 301R is provided on a part of the column signal processing unit 550, specifically, at a position overlapping a V-direction end of the column signal processing unit 550, for example. The contact units 202 and 302 transmit a pixel signal outputted from each of the multiple pixel sharing units 539 of the pixel array unit 540 (a signal corresponding to an amount of electric charges generated as a result of photoelectric conversion at the photodiode) to the column signal processing unit 550 provided on the third substrate 300, for example. The pixel signal is sent from the second substrate 200 to the third substrate 300.

As described above, FIG. 3 illustrates an exemplary cross-section of the imaging device 1. The first substrate 100, the second substrate 200, and the third substrate 300 are electrically coupled via the wiring layers 100T, 200T, and 300T. For example, the imaging device 1 includes an electrical coupling part that electrically couples the second substrate 200 and the third substrate 300. Specifically, the contact units 201, 202, 301, and 302 are formed using electrodes including an electrically conductive material. The electrically conductive material is, for example, a metal material such as copper (Cu), aluminum (Al), or gold (Au). The contact regions 201R, 202R, 301R, and 302R electrically couple the second substrate and the third substrate by directly joining wirings each formed as, for example, an electrode, allowing the second substrate 200 and the third substrate 300 to input or output signals.

The electrical coupling part electrically coupling the second substrate 200 and the third substrate 300 may be provided at a desired position. For example, the electrical coupling part may be provided in a region overlapping the pixel array unit 540 in the stacking direction, similarly to the contact regions 201R, 202R, 301R, and 302R described with reference to FIG. 3. Alternatively, the electrical coupling part may be provided in a region not overlapping the pixel array unit 540 in the stacking direction. Specifically, the electric coupling part may be provided in a region overlapping a surrounding portion provided outside the pixel array unit 540 in the stacking direction.

The first substrate 100 and the second substrate 200 are provided with coupling holes H1 and H2. The coupling holes H1 and H2 penetrate the first substrate 100 and the second substrate 200 (FIG. 3). The coupling holes H1 and H2 are provided outside the pixel array unit 540 (or the portion overlapping the pixel array unit 540) (FIG. 2). For example, the coupling hole H1 is arranged more outward than the pixel array unit 540 in the H-direction, and the coupling hole H2 is arranged more outward than the pixel array unit 540 in the V direction. For example, the coupling hole H1 reaches the input unit 510A provided on the third substrate 300, and the coupling hole H2 reaches the output unit 510B provided on the third substrate 300. The coupling holes H1 and H2 may be cavities or may include an electrically conductive material in at least a portion thereof. For example, a bonding wire may be coupled to an electrode formed as the input unit 510A and/or the output unit 510B. Alternatively, the electrode formed as the input unit 510A and/or the output unit 510B may be coupled to the electrically conductive material provided in the coupling holes H1 and H2. The electrically conductive material provided in the coupling holes H1 and H2 may be buried in all or part of the coupling holes H1 and H2. The electrically conductive material may be formed on side walls of the coupling holes H1 and H2.

It is to be noted that, although the input unit 510A and the output unit 510B are provided on the third substrate 300 in FIG. 3, this is non-limiting. For example, the input unit 510A and/or the output unit 510B may be provided on the second substrate 200 by transmitting signals from the third substrate 300 to the second substrate 200 via the wiring layers 200T and 300T. Likewise, the input unit 510A and/or the output unit 510B may be provided on the first substrate 100 by transmitting signals from the second substrate 200 to the first substrate 100 via the wiring layers 100T and 200T.

FIG. 4 is an equivalent circuit diagram illustrating an exemplary configuration of the pixel sharing unit 539. The pixel sharing unit 539 includes multiple pixels 541 (in FIG. 4A, four pixels 541 including the pixels 541A, 541B, 541C, and 541D), one pixel circuit 210 coupled to the multiple pixels 541, and the vertical signal line 543 coupled to the pixel circuit 210. The pixel circuit 210 includes, for example, four transistors. Specifically, the pixel circuit 210 includes an amplification transistor AMP, a selection transistor SEL, a reset transistor RST, and a FD conversion gain switching transistor FDG. As described above, the pixel sharing unit 539 sequentially outputs the respective pixel signals of the four pixels 541 (the pixels 541A, 541B, 541C, and 541D) included in the pixel sharing unit 539 to the vertical signal line 543 by operating the one pixel circuit 210 in a time-divisional manner. The configuration in which the one pixel circuit 210 is coupled to the multiple pixels 541 and the pixel signals of the multiple pixels 541 are outputted in the time-divisional manner is described as "the one pixel circuit 210 is shared between the multiple pixels 541".

The pixels 541A, 541B, 541C, and 541D include constituent elements common to each other. In the following, in order to distinguish the constituent elements of the pixels 541A, 541B, 541C, and 541D from each other, the constituent element of the pixel 541A is denoted with a reference numeral with a trailing identification number 1, the constituent element of the pixel 541B is denoted with a reference numeral with a trailing identification number 2, the constituent element of the pixel 541C is denoted with a reference numeral with a trailing identification number 3, and the constituent element of the pixel 541D is denoted with a reference numeral with a trailing identification number 4. In a case where the constituent elements of the pixels 541A, 541B, 541C, and 541D are not to be distinguished from each other, the trailing identification numbers of the reference numerals of the pixels 541A, 541B, 541C, and 541D are omitted.

The pixels 541A, 541B, 541C, and 541D each include, for example, the photodiode PD, the transfer transistor TR electrically coupled to the photodiode PD, and the floating diffusion FD electrically coupled to the transfer transistor TR. In the photodiode PD (PD1, PD2, PD3, and PD4), a cathode is electrically coupled to a source of the transfer transistor TR, and an anode is electrically coupled to a reference potential line (e.g., ground). The photodiode PD photoelectrically convers incident light to generate electric charges in accordance with a light reception amount. The transfer transistor TR (the transfer transistors TR1, TR2, TR3, and TR4) is, for example, an n-type MOS transistor. In the transfer transistor TR, a drain is electrically coupled to the floating diffusion FD, and a gate is electrically coupled to a driving signal line. The driving signal line is a part of the multiple row driving signal lines 542 (refer to FIG. 1) coupled to one pixel sharing unit 539. The transfer transistor TR transfers the electric charges generated at the photodiode PD to the floating diffusion FD. As described in detail later, the floating diffusion FD includes monocrystal silicon buried in a front surface (surface 100S1) of the semiconductor layer 100S at a central portion of the four pixels 541 (pixels 541A, 541B, 541C, and 541D) included in the pixel sharing unit 539, and an n-type impurity is diffused in the monocrystal silicon, for example. The floating diffusion FD is an electric charge holding means that temporarily holds the electric charges transferred from the photodiode PD, and is a charge-voltage conversion means that generates a voltage in accordance with the amount of electric charges. Here, the photodiode PD corresponds to a one specific example of a "photoelectric conversion unit" in the embodiment of the present disclosure, and the floating diffusion FD corresponds to one specific example of a "floating diffusion layer" in the embodiment of the disclosure.

The floating diffusion FD is electrically coupled to a gate of the amplification transistor AMP and a source of the FD conversion gain switching transistor FDG. A drain of the FD conversion gain switching transistor FDG is coupled to a source of the reset transistor RST, and a gate of the FD conversion gain switching transistor FDG is coupled to a driving signal line. The driving signal line is part of the multiple row driving signal lines 542 coupled to the one pixel sharing unit 539. A drain of the reset transistor RST is coupled to the power line VDD, and a gate of the reset transistor RST is coupled to a driving signal line. The driving signal line is part of the multiple row driving signal lines 542 coupled to the one pixel sharing unit 539. The gate of the amplification transistor AMP is coupled to the floating diffusion FD, a drain of the amplification transistor AMP is coupled to the power line VDD, and a source of the amplification transistor AMP is coupled to a drain of the selection transistor SEL. A source of the selection transistor SEL is coupled to the vertical signal line 543, and a gate of the selection transistor SEL is coupled to a driving signal line. The driving signal line is part of the multiple row driving signal lines 542 coupled to the one pixel sharing unit 539.

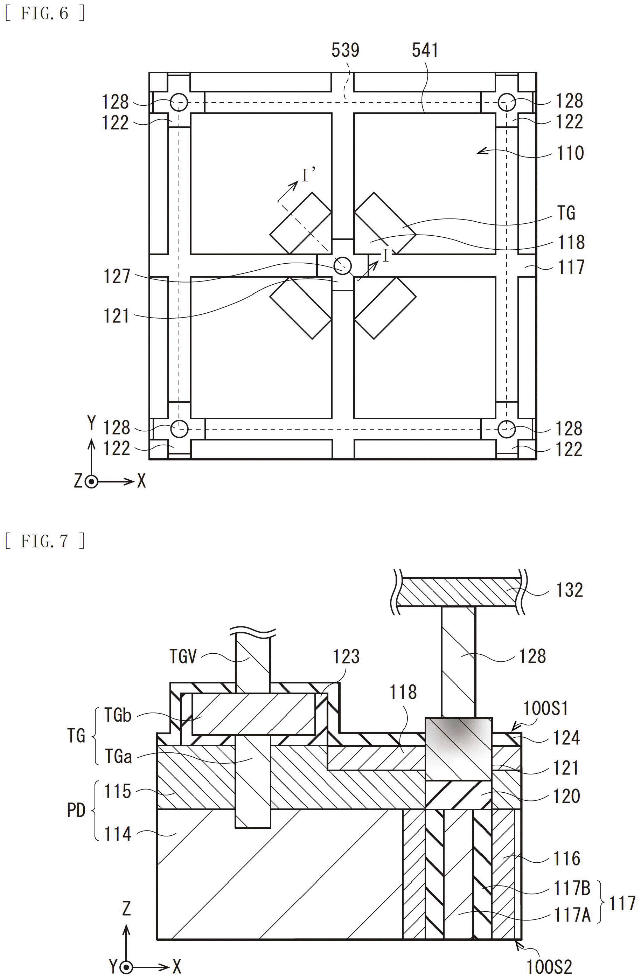

When the transfer transistor TR is turned on, the transfer transistor TR transfers the electric charges in the photodiode PD to the floating diffusion FD. A gate (transfer gate TG) of the transfer transistor TR includes, for example, a so-called longitudinal electrode, and as illustrated in FIGs. 5 and 7, extends from the front surface of the semiconductor layer (the semiconductor layer 100S of FIG. 5 described below) to a depth reaching the photodiode PD. The reset transistor RST resets a potential of the floating diffusion FD to a predetermined potential. When the reset transistor RST is turned on, the potential of the floating diffusion FD is reset to a potential of the power line VDD. The selection transistor SEL controls an output timing of the pixel signal from the pixel circuit 210. The amplification transistor AMP generates a voltage signal in accordance with a level of the electric charges held as the pixel signals in the floating diffusion FD. The amplification transistor AMP is coupled to the vertical signal line 543 via the selection transistor SEL. The amplification transistor AMP and the load circuit section (refer to FIG. 1) coupled to the vertical signal line 543 constitute a source follower in the column signal processing unit 550. When the selection transistor SEL is turned on, the amplification transistor AMP outputs the voltage of the floating diffusion FD to the column signal processing unit 550 via the vertical signal line 543. The reset transistor RST, the amplification transistor AMP, and the selection transistor SEL are, for example, n-type MOS transistors.

The FD conversion gain switching transistor FDG is used to change a gain for the charge-voltage conversion at the floating diffusion FD. In general, the pixel signal is small upon image capturing in a dark place. If the capacity of the floating diffusion FD (FD capacity C) is large upon the charge-voltage conversion based on a relation expression of a charge Q and a voltage V, Q = CV, a resultant voltage V after the voltage conversion at the amplification transistor AMP is small. In contrast, the pixel signal is large in a bright place, and if the FD capacity C is not large enough, the floating diffusion FD is not capable of receiving the electric charges of the photodiode PD. Further, the FD capacity C needs to be sufficiently large to prevent the voltage V after the voltage conversion at the amplification transistor AMP from becoming too large (in other words, so that the voltage V becomes small). Taking into consideration these points, when the FD conversion gain switching transistor FDG is turned on, the entire FD capacity C becomes larger by an increment of a wiring capacity to the reset transistor RST and the capacity of the FD conversion gain switching transistor FDG. In contrast, when the FD conversion gain switching transistor FDG is turned off, the entire FD capacity C becomes smaller. By switching the FD conversion gain switching transistor FDG between ON and OFF in this way, the FD capacity C may be made variable and conversion efficiency is made switchable. The FD conversion gain switching transistor FDG is, for example, an n-type MOS transistor.

It is to be noted that a configuration in which the FD conversion gain switching transistor FDG is not provided may be employed. In this case, for example, the pixel circuit 210 includes three transistors including the amplification transistor AMP, the selection transistor SEL, and the reset transistor RST.

The selection transistor SEL may be provided between the power line VDD and the amplification transistor AMP. In this case, the drain of the reset transistor RST is electrically coupled to the power line VDD and the drain of the selection transistor SEL. The source of the selection transistor SEL is electrically coupled to the drain of the amplification transistor AMP, and the gate of the selection transistor SEL is electrically coupled to the row driving signal line 542 (refer to FIG. 1). The source of the amplification transistor AMP (the output terminal of the pixel circuit 210) is electrically coupled to the vertical signal line 543, and the gate of the amplification transistor AMP is electrically coupled to the source of the reset transistor RST. It is to be noted that the number of pixels 541 sharing one pixel circuit 210 may be other than four. For example, two or eight pixels 541 may share the one pixel circuit 210.

### [Specific Configuration of Imaging Device]

FIG. 5 illustrates an exemplary cross-sectional configuration in the vertical direction with respect to principal surfaces of the first substrate 100, the second substrate 200, and the third substrate 300 of the imaging device 1. For easy understanding, positional relations between constituent elements are schematically illustrated in FIG. 5, which may thus be different from an actual cross-section. In the imaging device 1, the first substrate 100, the second substrate 200, and the third substrate 300 are stacked in this order. The imaging device 1 further includes a light reception lens 401 on the rear surface (light-incident surface) of the first substrate 100. A color filter (not illustrated) may be provided between the light reception lens 401 and the first substrate 100. The light reception lens 401 is provided in each of the pixels 541A, 541B, 541C, and 541D, for example. The imaging device 1 is, for example, a rear-surface irradiation light detecting device. The imaging device 1 includes the pixel array unit 540 arranged in a central portion and a surrounding unit 540B arranged outside the pixel array unit 540.

The first substrate 100 includes an insulating film 111, a fixed charge film 112, the semiconductor layer 100S, and the wiring layer 100T in order from the light reception lens 401. The semiconductor layer 100S is, for example, a silicon substrate. The semiconductor layer 100S includes, for example, a p-well layer 115 on a part of the front surface (the surface 100S1 close to the wiring layer 100T) or in the vicinity thereof, and includes an n-type semiconductor region 114 in another region (a region deeper than the p-well layer 115). For example, the n-type semiconductor region 114 and the p-well layer 115 constitute a p-n junction photodiode PD. The p-well layer 115 is a p-type semiconductor region. Here, the semiconductor layer 100S corresponds to one specific example of a "first semiconductor layer" of the embodiment of the present disclosure.

FIG. 6 illustrates an exemplary planar layout of the pixel sharing unit 539 on the first substrate 100. FIG. 7 schematically illustrates a cross-sectional configuration of the vicinity of the front surface (surface 100S1) of the semiconductor layer 100S taken along a line I-I' indicated in FIG. 6. In the vicinity of the surface 100S1 of the semiconductor layer 100S, a floating diffusion (FD) 121 and a VSS contact 122 are provided. The FD 121 and the VSS contact 122 are provided at or near an intersection of the four pixels 541 arranged in two rows and two columns above a pixel separation unit 117 to be described later. Specifically, the FD 121 is provided at a central portion of the pixel sharing unit 539, and the VSS contact 122 is provided at each of the four corners of the pixel sharing unit 539.

The FD 121 includes monocrystal silicon buried in the vicinity of the front surface (surface 100S1) of the semiconductor layer 100S, and a part of the FD 121 projects from the surface 100S1 of the semiconductor layer 100S. The monocrystal silicon included in the FD 121 includes an n-type impurity such as phosphorus (P) or arsenic (As) diffused therein, for example. The FD 121 may be provided at a central portion of the pixel sharing unit 539 as described above, and coupled to each of the pixels 541A, 541B, 541C, and 541D of the pixel sharing unit 539. In other words, the FD 121 is shared by the pixels 541A, 541B, 541C, and 541D of the pixel sharing unit 539. Further, the FD 121 is coupled from the first substrate 100 to the second substrate 200 (more specifically, from the wiring layer 100T to the wiring layer 200T) via an electric means (the through-electrode 128 to be described later). On the second substrate 200 (more specifically, inside the wiring layer 200T), the FD 121 is electrically coupled to the gate of the amplification transistor AMP and the source of the FD conversion gain switching transistor FDG by means of the electric means.

The VSS contact 122 includes monocrystal silicon buried in the vicinity of the front surface (surface 100S1) of the semiconductor layer 100S, and a part of the VSS contact 122 projects from the surface 100S1 of the semiconductor layer 100S. The monocrystal silicon included in the VSS contact 122 includes a p-type impurity such as boron (B) or indium (In) diffused therein, for example. The VSS contact 122 is a region electrically coupled to the reference potential line VSS, and is provided separately from the FD 121. Specifically, the VSS contact 122 is provided at each of the four corners of the pixel sharing unit 539, as described above. In other words, the VSS contact 122 is provided at or near the intersection of the four pixel sharing units 539 arranged in two rows and two columns. The VSS contact 122 is coupled to a grounding potential or a fixed potential, for example.

In the vicinity of the surface 100S1 of the semiconductor layer 100S, a LDD region 118 and a VSS contact region 119 are further provided. The LDD region 118 is an n-type semiconductor region provided inside the p-well layer 115. The VSS contact region 119 is, for example, a p-type semiconductor region. The LDD region 118 is provided in each of the pixels 541. The LDD regions 118 provided in the respective pixels 541A, 541B, 541C, and 541D of the pixel sharing unit 539 are provided close to each other so as to be adjacent to the FD 121 provided in the central portion of the pixel sharing unit 539. The VSS contact region 119 is provided separately from the LDD region 118. For example, the LDD region 118 is provided at one end of each of the pixels 541A, 541B, 541C, and 541D in the V-direction, and the VSS contact region 119 is provided at another end of the pixel. The VSS contact region 119 is provided adjacent to the VSS contact 122, allowing the semiconductor layer 100S to be supplied with a reference potential.

On the first substrate 100, the transfer transistor TR is provided as well as the photodiode PD, the FD 121 , the VSS contact 122, the LDD region 118, and the VSS contact region 119. The photodiode PD, the LDD region 118, the VSS contact region 119, and the transfer transistor TR are provided in each of the pixels 541A, 541B, 541C, and 541D. The transfer transistor TR is provided on the front surface (the surface 100S1 opposite to the light incident surface and close to the second substrate 200) of the semiconductor layer 100S. The transfer transistor TR includes the transfer gate TG. The transfer gate TG includes, for example, a horizontal portion TGb opposed to the front surface of the semiconductor layer 100S, and a vertical portion TGa provided inside the semiconductor layer 100S. The vertical portion TGa extends in a thickness direction of the semiconductor layer 100S. One end of the vertical portion TGa is in contact with the horizontal portion TGb, and the other end is provided inside the n-type semiconductor region 114. The transfer transistor TR configured by such a longitudinal transistor makes it possible to substantially prevent a transfer failure of a pixel signal from occurring and to improve efficiency in reading the pixel signal.

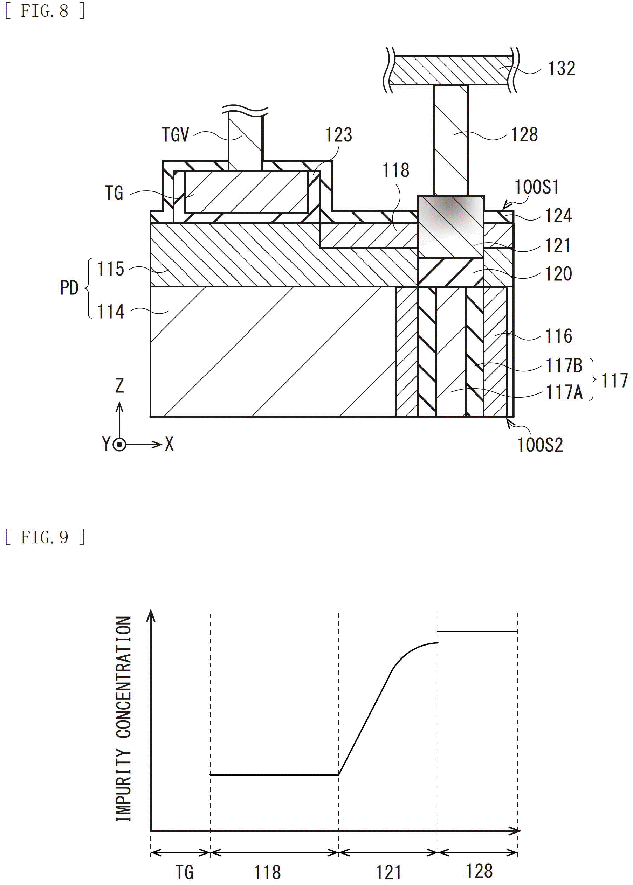

It is to be noted that, as illustrated in FIG. 8, the transfer transistor TR may be a planar transistor. In this case, for example, the transfer gate TG is provided on the surface 100S1 of the semiconductor layer 100S. A gate insulating film 123 is provided between the semiconductor layer 100S and the transfer gate TG. In the example described in FIG. 8, the gate insulating film 123 extends along sides of the transfer gate TG. However, the sides of the transfer gate TG may be covered with a side wall SW. The side wall SW includes, for example, silicon nitride (SiN). The transfer gates TG (transfer gates TG1, TG2, TG3, and TG4) of the respective pixels 541A, 541B, 541C, and 541D are provided so as to surround the FD 121 and the LDD region 118 in plan view, for example (refer to FIG. 6, for example).

The semiconductor layer 100S is provided with the pixel separation unit 117 that separates the pixels 541A, 541B, 541C, and 541D from each other. The pixel separation unit 117 is formed to extend in a normal direction of the semiconductor layer 100S (a direction vertical to the front surface (surface 100S1) of the semiconductor layer 100S (e.g., a Z-axis direction)). The pixel separation unit 117 is provided to partition the pixels 541A, 541B, 541C, and 541D from each other, and has a lattice shape in plan view, for example. The pixel separation unit 117 electrically and optically separates the pixels 541A, 541B, 541C, and 541D from each other, for example. The pixel separation unit 117 includes, for example, a light shielding film 117A and an insulating film 117B. The light shielding film 117A includes, for example, a metal material such as tungsten (W). The light shielding film 117A may be configured to receive a predetermined potential. The insulating film 117B is provided between the light shielding film 117A and the p-well layer 115 or the n-type semiconductor region 114. The insulating film 117B includes, for example, silicon oxide (SiO). The pixel separation unit 117 has, for example, a full trench isolation (FTI) structure, and penetrates the semiconductor layer 100S. Although not illustrated, the pixel separation unit 117 is not limited to the FTI structure that penetrates the semiconductor layer 100S. For example, the pixel separation unit 117 may have a deep trench isolation (DTI) structure not penetrating the semiconductor layer 100S. The pixel separation unit 117 extends in the normal direction of the semiconductor layer 100S and is formed in part of the region of the semiconductor layer 100S.

In the semiconductor layer 100S, a first pinning region 113 and a second pinning region 116 are provided, for example. The first pinning region 113 is provided in the vicinity of a rear surface (surface 100S2) of the semiconductor layer 100S, and is arranged between the n-type semiconductor region 114 and the fixed charge film 112. The second pinning region 116 is provided on a side surface of the pixel separation unit 117, specifically, between the pixel separation unit 117 and the p-well layer 115 or the n-type semiconductor region 114. The first pinning region 113 and the second pinning region 116 are p-type semiconductor regions, for example.

The fixed charge film 112 having a negative fixed charge is provided between the semiconductor layer 100S and the insulating film 111. Owing to an electric field induced by the fixed charge film 112, the first pinning region 113 of a hole accumulation layer is formed at an interface close to the light receiving surface (rear surface) of the semiconductor layer 100S. This suppresses an occurrence of a dark current caused by an interface state of the light receiving surface of the semiconductor layer 100S. The fixed charge film 112 is formed using an insulating film having a negative fixed charge, for example. Examples of a material of the insulating film having a negative fixed charge include hafnium oxide, zircon oxide, aluminum oxide, titanium oxide, or tantalum oxide.

A light shielding film 117C is provided between the fixed charge film 112 and the insulating film 111. The light shielding film 117C may be provided continuously to the light shielding film 117A of the pixel separation unit 117. The light shielding film 117C between the fixed charge film 112 and the insulating film 111 may be selectively provided at a location opposed to the pixel separation unit 117 within the semiconductor layer 100S. The insulating film 111 is provided to cover the light shielding film 117A. The insulating film 111 includes, for example, silicon oxide.

The wiring layer 100T provided between the semiconductor layer 100S and the second substrate 200 includes the gate insulating film 123, an interlayer insulating film 124, a passivation film 125, an interlayer insulating film 126, and a bonding film 127 in this order from the semiconductor layer 100S. The interlayer insulating film 126 includes one or more wiring layers (e.g., wiring layer 132). The horizontal portion TGb of the transfer gate TG is provided on the wiring layer 100T, for example. The interlayer insulating film 124 is provided over the entire surface of the semiconductor layer 100S, and is in contact with the semiconductor layer 100S. The interlayer insulating film 124 is, for example, a silicon oxide film. It is to be noted that the configuration of the wiring layer 100T is not limited to the configuration described above, and may be any configuration including wirings and an insulating film.

The passivation film 125 is provided over the entire surface of the semiconductor layer 100S to cover the FD 121 and the VSS contact 122, for example. The passivation film 125 is, for example, a silicon nitride (SiN) film. The interlayer insulating film 126 covers the FD 121 and the VSS contact 122 with the passivation film 125 interposed therebetween. The interlayer insulating film 126 is provided over the entire surface of the semiconductor layer 100S, for example. The interlayer insulating film 126 is, for example, a silicon oxide (SiO) film. The bonding film 127 is provided on a bonding surface between the first substrate 100 (specifically, the wiring layer 100T) and the second substrate 200. That is, the bonding film 127 is in contact with the second substrate 200. The bonding film 127 is provided over an entire principal surface of the first substrate 100. The bonding film 127 is, for example, a silicon nitride film.

On the wiring layer 100T, the through-electrodes 128 and 129 and a through-electrode TGV electrically coupling the first substrate 100 and the second substrate 200 extend in the thickness direction (Z-axis direction) of the wiring layer 100T. Upper ends of the through-electrodes 128 and 129 and the through-electrode TGV are coupled to the wirings of the wiring layer 200T. Lower ends of the through the through-electrodes 128 and 129 and the through-electrode TGV each penetrate an insulating region 212 to be described later, the bonding film 127, the interlayer insulating film 126, and the passivation film 125, and are directly coupled to the FD 121, the VSS contact 122, and the transfer gate TG, for example. The through-electrodes 128 and 129 and the through-electrode TGV include, for example, polysilicon (Poly Si), more specifically, doped polysilicon to which an impurity is added. The wiring layer 132 includes, for example, a metal material including one or more of polysilicon (Poly Si), titanium (Ti) titanium nitride (TiN), and tungsten (W).

FIG. 9 is a concentration profile of the n-type impurity included in the transfer gate TG, the LDD region 118, the FD 121, and the through-electrode 128. The LDD region 118, the FD 121, and the through-electrode 128 in the imaging device 1 of the present embodiment include, for example, an n-type impurity, and, as illustrated in FIG. 9, have an impurity concentration gradient in which the concentration of the n-type impurity included from the through-electrode 128 to the transfer gate TG gradually decreases. This mitigates an electric field between the FD 121 and the transfer transistor TR, suppressing generation of FD white spots upon miniaturization.

It is to be noted that the same applies to the through-electrode 129 coupled to the VSS contact 122, the VSS contact region 119, and the VSS contact 122. The impurity concentration gradient may be formed in which the concentration of the included p-type impurity gradually decreases in order of the through-electrode 129, the VSS contact 122, and the VSS contact region 119.

The light reception lens 401 is opposed to the semiconductor layer 100S with the fixed charge film 112 and the insulating film 111 interposed therebetween, for example. The light reception lens 401 is provided at a location opposed to the photodiode PD of each of the pixels 541A, 541B, 541C, and 541D, for example.

The second substrate 200 includes the semiconductor layer 200S and the wiring layer 200T in this order from the first substrate 100. The semiconductor layer 200S is a silicon substrate. A well region 211 is provided in a thickness direction of the semiconductor layer 200S. The well region 211 is, for example, a p-type semiconductor region. The pixel circuit 210 arranged in each pixel sharing unit 539 is provided on the second substrate 200. The pixel circuit 210 is provided on the front surface of the semiconductor layer 200S (the wiring layer 200T), for example. In the imaging device 1, the second substrate 200 is bonded to the first substrate 100 in such a manner that the front surface of the first substrate 100 (close to the wiring layer 100T) faces the rear surface of the second substrate 200 (close to the semiconductor layer 200S). That is, the second substrate 200 is bonded to the first substrate 100 in a face-to-back manner. Here, the semiconductor layer 200S corresponds to one specific example of a "second semiconductor layer" of the embodiment of the present disclosure.

On the second substrate 200, the insulating region 212 dividing the semiconductor layer 200S and an element separation region 213 provided at a part of the semiconductor layer 200S in the thickness direction are provided. For example, in the insulating region 212 provided between two pixel circuits 210 adjacent to each other in an H-direction, the through-electrodes 128 and 129 and the through-electrode TGV of the two pixel sharing units 539 that are coupled to the two pixel circuits 210 are arranged.

The insulating region 212 has substantially the same thickness as the semiconductor layer 200S. The semiconductor layer 200S is divided by the insulating region 212. In the insulating region 212, the through-electrode 128 and 129 and the through-electrode TGV are arranged. The insulating region 212 includes, for example, silicon oxide.

The through-electrodes 128 and 129 are provided to penetrate the insulating region 212 in the thickness direction. Upper ends of the through-electrodes 128 and 129 are coupled to wirings (a first wiring layer W1, a second wiring layer W2, a third wiring layer W3, and a fourth wiring layer W4) of the wiring layer 200T. Lower ends of the through-electrodes 128 and 129 each penetrate the insulating region 212, the bonding film 127, the interlayer insulating film 126, and the passivation film 125, and are coupled to the FD 121 and the VSS contact 122. The through-electrode 128 is used to electrically couple the FD 121 and the pixel circuit 210. The through-electrode 129 is used to electrically couple the VSS contact 122 and the reference potential line VSS of the wiring layer 200T. That is, the through-electrode 129 electrically couples the VSS contact region 119 of the first substrate 100 to the reference potential line VSS of the second substrate 200.

The through-electrode TGV is provided to penetrate the insulating region 212 in the thickness direction. An upper end of the through-electrode TGV is coupled to the wirings of the wiring layer 200T. A lower end of the through-electrode TGV is provided to penetrate the insulating region 212, the bonding film 127, the interlayer insulating film 126, the passivation film 125, and the interlayer insulating film 124, and is coupled to the transfer gate TG. The through-electrode TGV is used to electrically couple the transfer gate TG (the transfer gates TG1, TG2, TG3, and TG4) of each of the pixels 541A, 541B, 541C, and 541D and the wiring of the wiring layer 200T (part of the row driving signal lines 542). That is, the through-electrode TGV electrically couples the transfer gate TG of the first substrate 100 to a wiring TRG of the second substrate 200, and a driving signal is sent to each of the transfer transistors TR (the transfer transistors TR1, TR2, TR3, and TR4).

The insulating region 212 is a region in which the through-electrodes 128 and 129 and the through-electrode TGV for electrically coupling the first substrate 100 and the second substrate 200 are provided so as to be insulated from the semiconductor layer 200S. For example, in the insulating region 212 provided between two pixel circuits 210 (pixel sharing units 539) adjacent to each other in the H-direction, the through-electrodes 128 and 129 and the through-electrode TGV coupled to these two pixel circuits 210 are provided.

The element separation region 213 is provided on the front surface of the semiconductor layer 200S. The element separation region 213 has a shallow trench isolation (STI) structure. In the element separation region 213, the semiconductor layer 200S is trenched in the thickness direction (the direction vertical to the principal surface of the second substrate 200), and the trenched portion is filled with an insulating film. The insulating film includes, for example, silicon oxide. The element separation region 213 achieves element separation between the multiple transistors of the pixel circuit 210 in accordance with the layout of the pixel circuit 210. The semiconductor layer 200S (specifically, the well region 211) extends below the element separation region 213 (in a deep portion of the semiconductor layer 200S).

The wiring layer 200T includes, for example, a passivation film 221, an interlayer insulating film 222, and multiple wirings (a first wiring layer W1, a second wiring layer W2, a third wiring layer W3, and the fourth wiring layer W4). For example, the passivation film 221 is in contact with the front surface of the semiconductor layer 200S, and entirely covers the front surface of the semiconductor layer 200S. The passivation film 221 covers respective gate electrodes of the selection transistor SEL, the amplification transistor AMP, the reset transistor RST, and the FD conversion gain switching transistor FDG. The interlayer insulating film 222 is provided between the passivation film 221 and the third substrate 300. The interlayer insulating film 222 separates the multiple wirings (the first wiring layer W1, the second wiring layer W2, the third wiring layer W3, and the fourth wiring layer W4). The interlayer insulating film 222 includes, for example, silicon oxide. The multiple wirings (the first wiring layer W1, the second wiring layer W2, the third wiring layer W3, and the fourth wiring layer W4) each include a metal material including one or more of polysilicon (Poly Si), titanium (Ti), titanium nitride (TiN), and tungsten (W), for example
In the wiring layer 200T, for example, the first wiring layer W1, the second wiring layer W2, the third wiring layer W3, the fourth wiring layer W4, and the contact units 201 and 202 are provided in this order from the semiconductor layer 200S, and these are insulated from each other by the interlayer insulating film 222. In the interlayer insulating film 222, a plurality of coupling parts is provided that couples the first wiring layer W1, the second wiring layer W2, the third wiring layer W3, or the fourth wiring layer W4, and layers provided below these layers. The coupling part is a portion of the interlayer insulating film 222 where an electrically conductive material is buried in a coupling hole. For example, in the interlayer insulating film 222, a coupling part 218V that couples the first wiring layer W1 and the VSS contact region 218 of the semiconductor layer 200S is provided. The coupling part 218V is provided at a location opposed to the semiconductor layer 200S.

For example, the first wiring layer W1 couples the through-electrode 128, the gate of the amplification transistor AMP, and the source of the FD conversion gain switching transistor FDG (specifically, a coupling hole reaching the source of the FD conversion gain switching transistor FDG). The first wiring layer W1 couples, for example, the through-electrode 129 and the coupling part 218V. This electrically couples the VSS contact region 218 of the semiconductor layer 200S and the VSS contact region 119 of the semiconductor layer 100S.

The contact units 201 and 202 may be provided at locations overlapping the pixel array unit 540 in plan view or may be provided in a surrounding unit 540B outside the pixel array unit 540. The contact units 201 and 202 are provided on a front surface (a surface close to the wiring layer 200T) of the second substrate 200. The contact units 201 and 202 include, for example, metal such as copper (Cu) or aluminum (Al). The contact units 201 and 202 are exposed on a front surface (a surface close to the third substrate 300) of the wiring layer 200T. The contact units 201 and 202 are used to electrically couple the second substrate 200 and the third substrate 300 and o bond the second substrate 200 to the third substrate 300.

The third substrate 300 includes, for example, a wiring layer 300T and a semiconductor layer 300S in this order from the second substrate 200. For example, a front surface of the semiconductor layer 300S is provided close to the second substrate 200. The semiconductor layer 300S is a silicon substrate. Circuitry is provided on the front surface portion of the semiconductor layer 300S. Specifically, on the front surface portion of the semiconductor layer 300S, for example, at least part of an input unit 510A, a row driving unit 520, a timing control unit 530, a column signal processing unit 550, an image signal processing unit 560, and an output unit 510B is provided. The wiring layer 300T provided between the semiconductor layer 300S and the second substrate 200 includes, for example, an interlayer insulating film, multiple wiring layers separated by the interlayer insulating film, and the contact units 301 and 302. The contact units 301 and 302 are exposed on a front surface (a surface close to the second substrate 200) of the wiring layer 300T. The contact unit 301 is in contact with the contact unit 201 of the second substrate 200, and the contact unit 302 is in contact with the contact unit 202 of the second substrate 200. The contact units 301 and 302 are electrically coupled to the circuitry (e.g., one or more of the input unit 510A, the row driving unit 520, the timing control unit 530, the column signal processing unit 550, the image signal processing unit 560, and the output unit 510B) formed on the semiconductor layer 300S. The contact units 301 and 302 include, for example, metal such as copper (Cu) or aluminum (Al). For example, an outside terminal TA is coupled to the input unit 510A via a coupling hole H1, and an outside terminal TB is coupled to the output unit 510B via a coupling hole H2.

### [Method of Manufacturing Imaging Device]

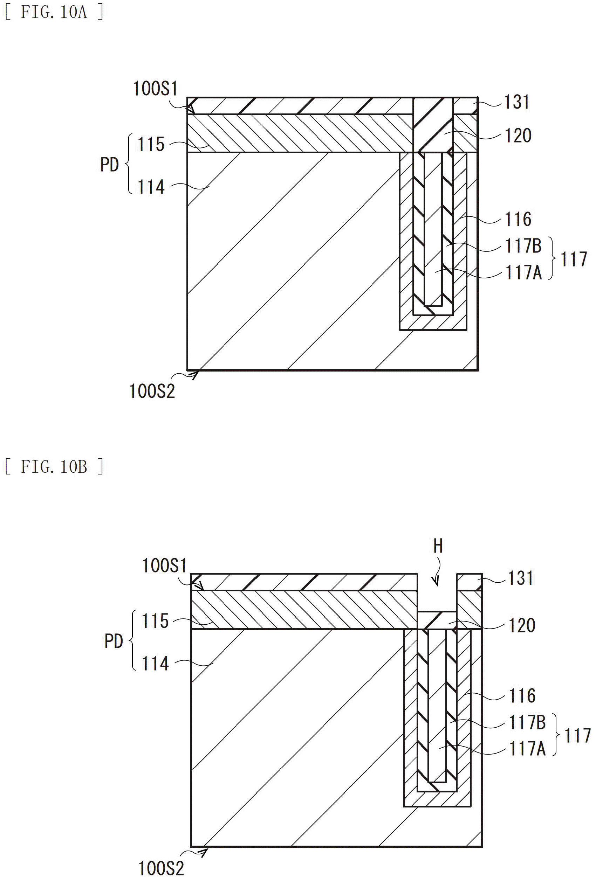

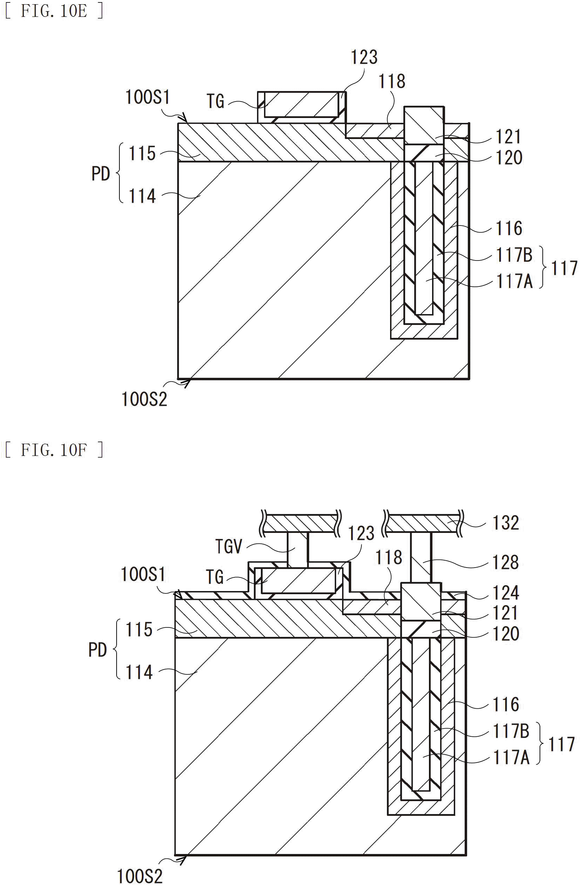

FIGs. 10A to 10H illustrate an exemplary method of manufacturing an imaging device 1 (in particular, the first substrate 100) illustrated in FIG. 1.

First, the pixel separation unit 117 is formed from the surface 100S1 of the semiconductor layer 100S, and a mask 131 is patterned on the surface 100S1 of the semiconductor layer 100S. Thereafter, as illustrated in FIG. 10A, the insulating film 120 is buried above the pixel separation unit 17.

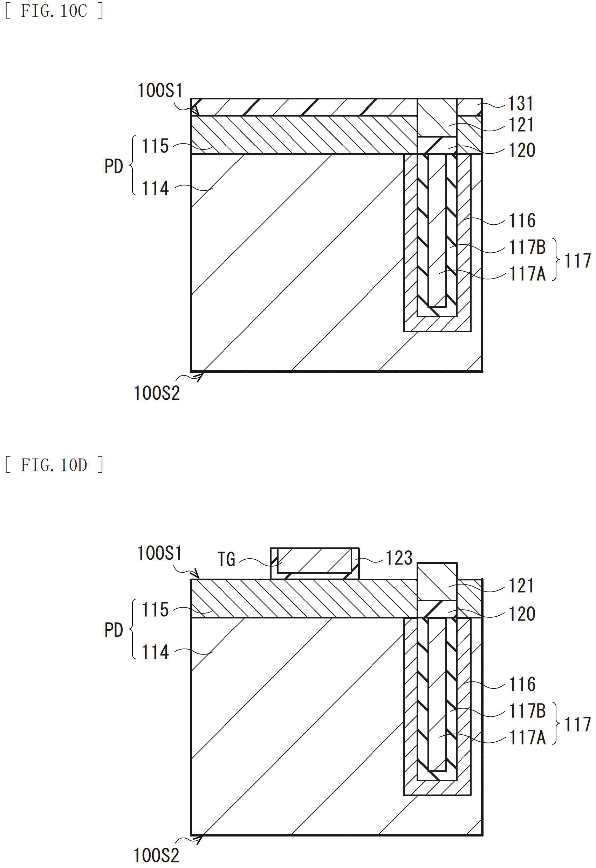

Next, as illustrated in FIG. 10B, for example, the insulating film 120 is partially etched to form an opening H, and the silicon substrate is exposed at side faces of the opening H. Thereafter, as illustrated in FIG. 10C, the silicon is epitaxially grown selectively in the opening H. Accordingly, the FD 121 including monocrystal silicon is formed.

Next, the mask 131 is removed, following which, as illustrated in FIG. 10D, the gate insulating film 123 and the transfer gate TG are formed on the surface 100S1 of the semiconductor layer 100S. Thereafter, as illustrated in FIG. 10E, the LDD region 118 is formed between the FD 121 and the transfer gate TG by ion implantation, for example. Next, the interlayer insulating film 124 or the like is formed, following which, as illustrated in 10F, the through-electrode 128 and the through-electrode TGV each including polysilicon are formed. Further, the wiring including, for example, polysilicon (e.g., the wiring layer 132) is formed.

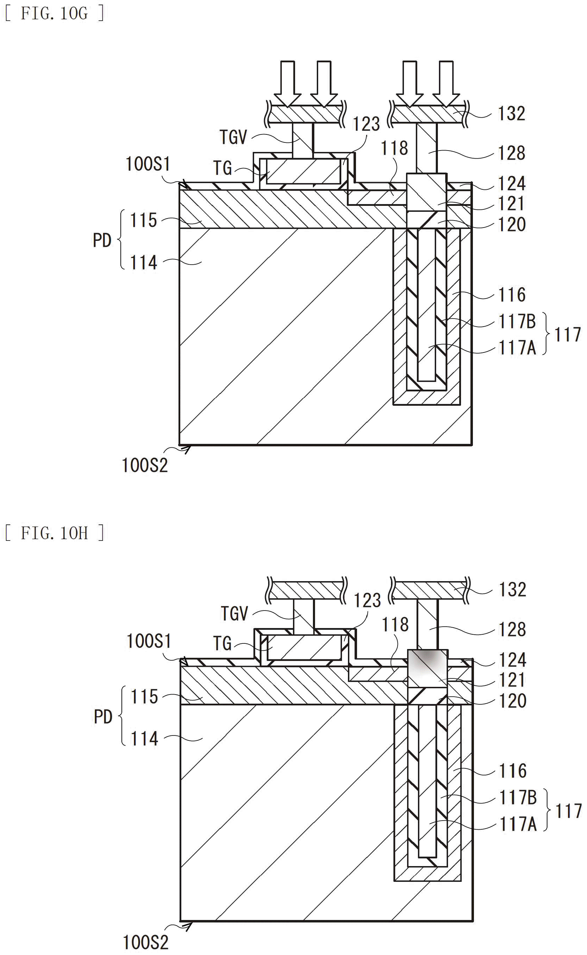

Thereafter, as illustrated in FIG. 10G, an impurity is injected in the wiring layer 132 by ion implantation. Next, as illustrated in FIG. 10H, the impurity injected in the wiring layer 132 is diffused by thermal diffusion. Accordingly, the impurity concentration gradient in which the concentration of the impurity gradually decreases in order of the through-electrode 128, the FD 121, and the LDD region 118 is formed, as illustrated in FIG. 9.

It is to be noted that, in the FD 121 formed in this manner, the impurity concentration gradient is formed in which the concentration of the impurity gradually decreases from a coupling part with the through-electrode 128.

The concentration of the impurity included in the LDD region 118, the FD 121, and the through-electrode 128 and the impurity concentration gradient may be measured by, for example, scanning spread resistance microscopy (SSRM) or scanning microwave impedance microscopy (sMIM).

### [Operation of Imaging Device]

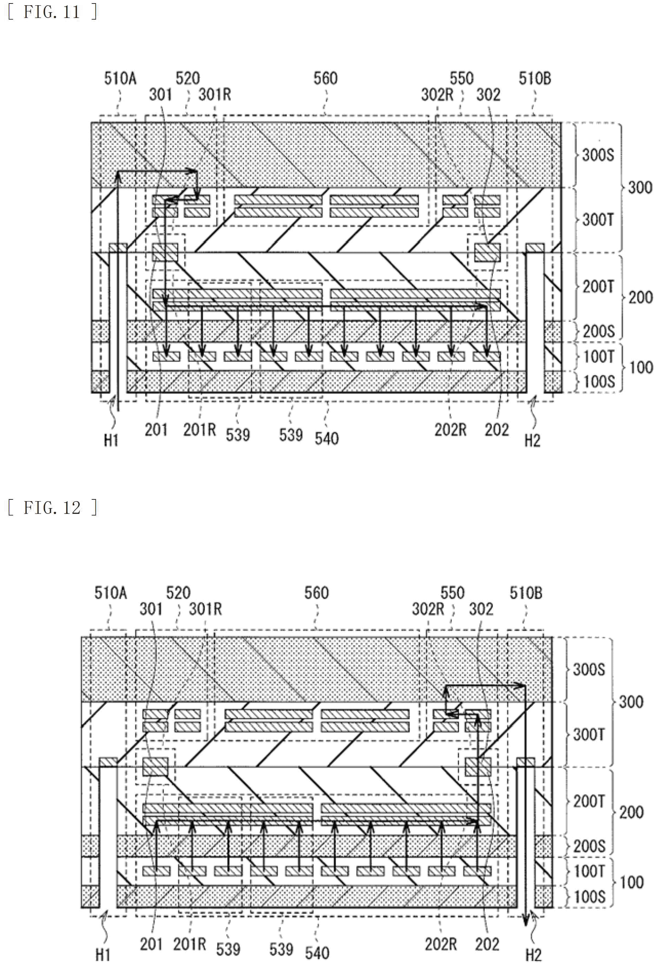

Next, an operation of the imaging device 1 is described with reference to FIGs. 11 and 12. FIGs. 11 and 12 each corresponds to FIG. 3 to which an arrow indicating a path of each signal is added. In FIG. 11, paths of an input signal inputted from the outside to the imaging device 1, a power potential, and a reference potential are indicated by arrows. In FIG. 12, a signal path of a pixel signal outputted from the imaging device 1 to the outside is represented by an arrow. For example, an input signal (e.g., a pixel clock and a synchronization signal) received by the imaging device 1 via the input unit 510A is transferred to the row driving unit 520 of the third substrate 300, and a row driving signal is generated at the row driving unit 520. The row driving signal is sent to the second substrate 200 via the contact units 301 and 201. Further, the row driving signal reaches each of the pixel sharing units 539 of the pixel array unit 540 via the row driving signal line 542 inside the wiring layer 200T. Among the row driving signals having reached the pixel sharing unit 539 of the second substrate 200, the driving signal other than that for the transfer gate TG is received by the pixel circuit 210 to drive each transistor included in the pixel circuit 210. The driving signal of the transfer gate TG is received by the transfer gates TG1, TG2, TG3, and TG4 of the first substrate 100 via the through-electrode TGV, and the pixels 541A, 541B, 541C, and 541D are driven (FIG. 11). Further, the power potential and the reference potential supplied from the outside of the imaging device 1 to the input unit 510A (input terminal 511) of the third substrate 300 are sent to the second substrate 200 via the contact units 301 and 201, and supplied to each pixel circuit 210 of the pixel sharing unit 539 via the wiring inside the wiring layer 200T. The reference potential is also supplied to the pixels 541A, 541B, 541C, and 541D of the first substrate 100 via the through-electrode 129. In contrast, the pixel signals photoelectrically converted at the pixels 541A, 541B, 541C, and 541D of the first substrate 100 are sent to the pixel circuit 210 of the second substrate 200 via the through-electrode 128 for each pixel sharing unit 539. The signals based on the pixel signals are sent to the third substrate 300 via from the pixel circuit 210 to the vertical signal line 543 and the contact units 202 and 302. The pixel signals are processed at the column signal processing unit 550 and the image signal processing unit 560 of the third substrate 300, and thereafter outputted to the outside via the output unit 510B (FIG. 12).

### [Workings and Effects]

According to the imaging device 1 of the present embodiment, the FD 121 including, for example, monocrystal silicon is buried above the pixel separation unit 17, and the through-electrode 128 including polysilicon is directly coupled above the FD 121. This mitigates an electrical field between the FD 121 and the transfer transistor TR. This effect is described in the following.

As described above, in a case of a miniaturized imaging device in which a buried electrode is provided on a separation unit arranged on an interface between pixels, and a charge holding unit is formed on a front surface of a semiconductor substrate while ohmic contact is secured with respect to the buried electrode by side contact, a PN electric field between a gate of a transfer transistor and the charge holding unit becomes stronger. This increases the number of FD white spots.

In contrast, according to the present embodiment described above, the FD 121 is buried above the pixel separation unit 17, and the through-electrode 128 including polysilicon is directly coupled above the FD 121. This makes it possible to secure the distance between the FD 121 and the transfer transistor TR. Thus, the electric field between the FD 121 and the transfer transistor TR is mitigated.

It is possible for the imaging device 1 of the present embodiment described above to suppress an increase in the number of FD white spots upon miniaturization of the pixels. This makes it possible to improve reliability. It is therefore possible to provide a high-resolution imaging device having high reliability.

Further, according to the imaging device 1 of the present embodiment, in the transfer transistor TR, the FD 121, the LDD region 118, and the through-electrode 128 each provided on the front surface (surface 100S1) of the semiconductor layer 100S, the impurity concentration gradient is formed in which the concentration of the contained impurity decreases in order of the through-electrode 128, the FD 121, and the LDD region 118. This further mitigates the electric field between the FD 121 and the transfer transistor TR. Accordingly, it is possible to further suppress an increase in the number of FD white spots upon miniaturization of the pixels. This makes it possible to further improve the reliability.

In the following, Modification Examples 1 to 7, an application example, and a practical example of the present disclosure are described. In the following modification examples, a description is given by assigning the same reference numerals to components common to those in the first embodiment.

### <2. Modification Example 1>

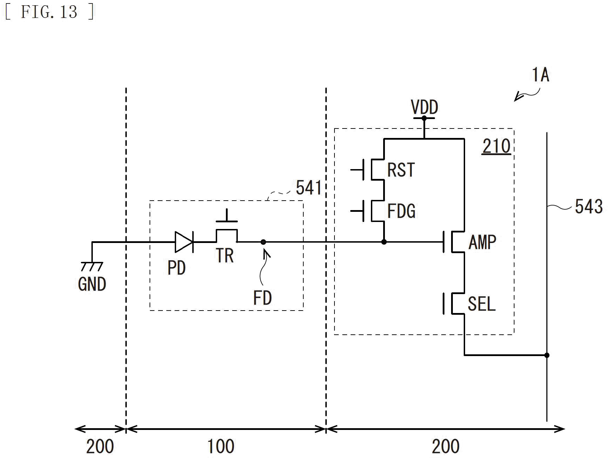

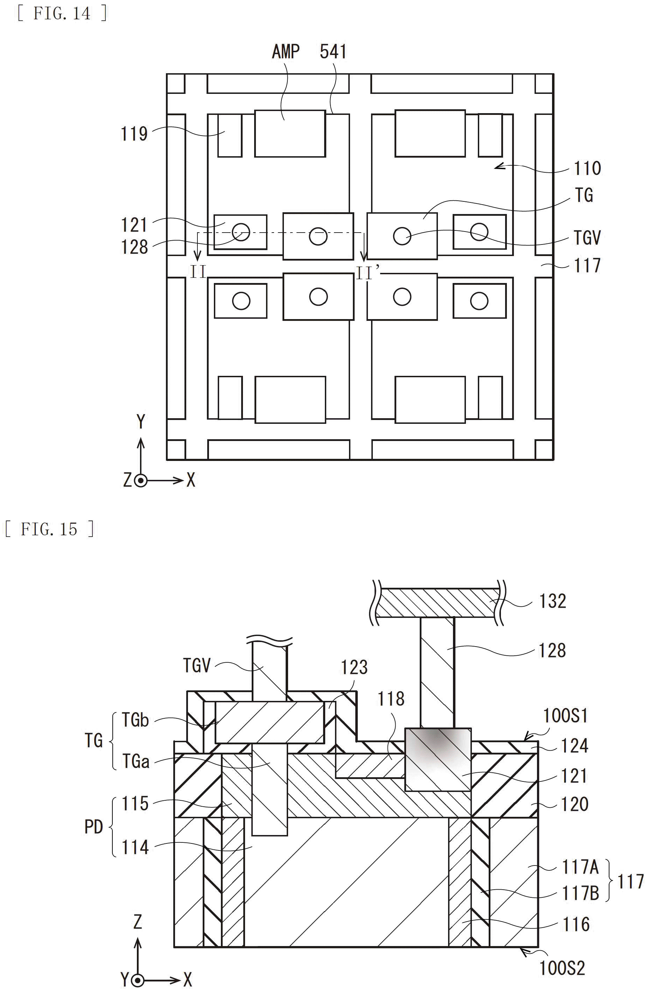

FIG. 13 is an exemplary equivalent circuit diagram of the pixel sharing unit in a light detecting device (e.g., an imaging device 1A) according to Modification Example 1 of the present disclosure. FIG. 14 schematically illustrates an exemplary planar layout of the pixel sharing unit 539 having the circuit configuration illustrated in FIG. 13 and provided on a first substrate 100 of the imaging device 1A. FIG. 15 schematically illustrates an exemplary cross-sectional configuration of the vicinity of the front surface (surface 100S1) of the semiconductor layer 100S taken along a line II-II' of FIG. 14.

In the example described in the first embodiment described above, the four pixels (pixels 541A, 541B, 541C, and 541D) of the pixel sharing unit 539 share the pixel circuit 210; however, this is non-limiting. In the imaging device 1A of the present modification example, the pixel circuit 210 is provided in each pixel 541, as illustrated in FIG. 13.

In this case, as illustrated in FIG. 14, the FD 121 and the VSS contact 122 are formed in an active region 110 of the semiconductor layer 100S for each pixel 541. Specifically, as illustrated in FIG. 15, the FD 121 is provided in the active region 110 of each pixel 541 along the insulating film 120 buried above the pixel separation unit 17, for example. Similarly, the VSS contact 122 is provided in the active region 110 of each pixel along the insulating film 120 buried above the pixel separation unit 17, for example, although not illustrated in the drawings.

Also in this configuration, the imaging device 1A of the present modification example makes it possible to provide effects similar to those in the first embodiment.

### <3. Second Embodiment>

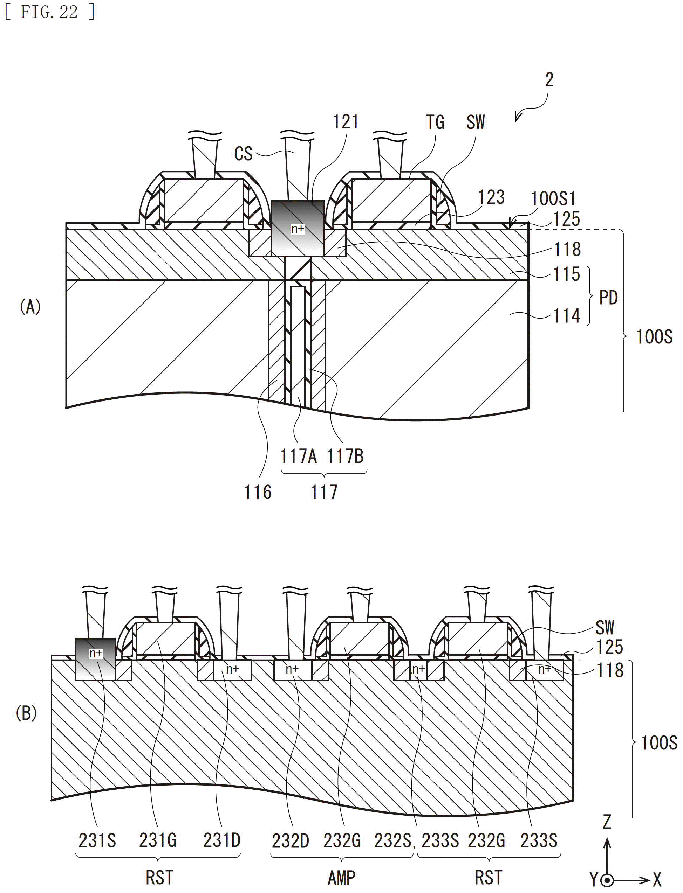

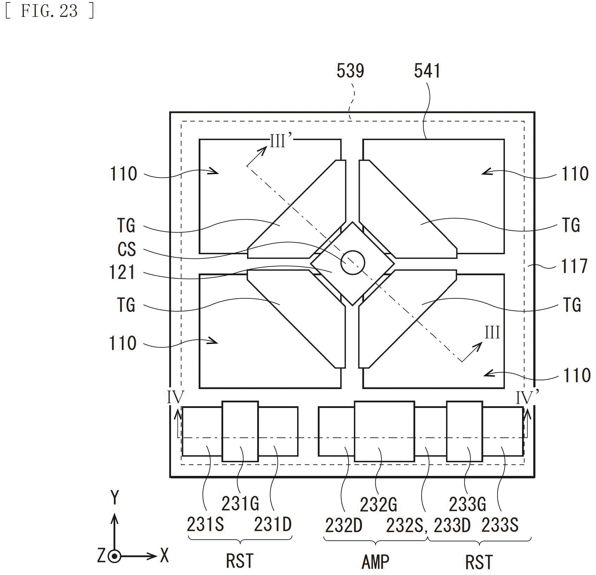

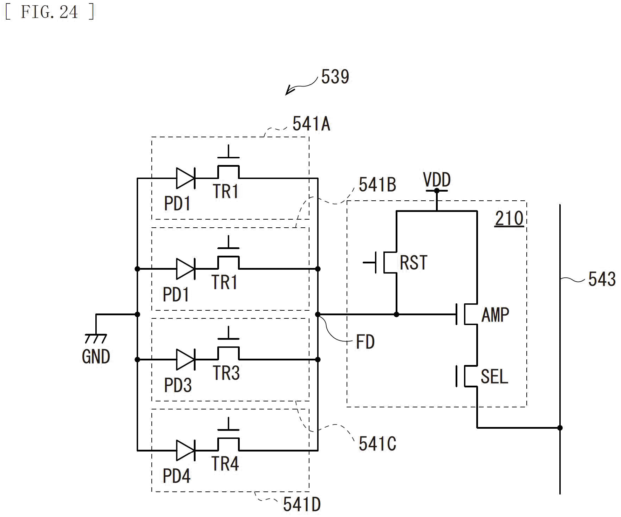

FIG. 22 schematically illustrates an exemplary cross-sectional configuration of the first substrate 100 of a light detecting device (e.g., an imaging device 2) according to a second embodiment of the present disclosure. FIG. 23 schematically illustrates an exemplary planar layout of the pixel sharing unit 539 of the imaging device 2. Part (A) of FIG. 22 illustrates an exemplary cross-sectional configuration of the vicinity of the front surface (surface 100S1) of the semiconductor layer 100S taken along a line III-III' illustrated in FIG. 23, and Part (B) of FIG. 22 illustrates an exemplary cross-sectional configuration of the vicinity of the front surface (surface 100S1) of the semiconductor layer 100S taken along a line IV-IV' illustrated in FIG. 23. FIG. 24 is an exemplary equivalent circuit diagram of the imaging device 2.

### [Outline Configuration of Imaging Device]

The imaging device 2 of the present embodiment includes, for example, the photodiode PD, the floating diffusion (FD) 121, the transfer transistor TR, and the pixel circuit 210 that are provided on one semiconductor substrate. That is, comparing with the configuration of the imaging device 1 of the first embodiment described above, the imaging device 2 has a three-dimensional configuration in which the second substrate 200 is omitted and two substrates (the first substrate 100 and the third substrate 300) are bonded to each other.

The imaging device 2 includes the photodiode PD, the floating diffusion (FD) 121, the transfer transistor TR, and a plurality of transistors of the pixel circuit 210 on the surface 100S1 opposite to the light receiving surface 100S2 of the semiconductor layer 100S having paired surfaces (surfaces 100S1 and 100S2) opposed to each other. The pixel circuit 210 includes, as the plurality of transistors, a reset transistor RST, an amplification transistor AMP, and a selection transistor SEL, for example. In the present embodiment, the FD 121 and an upper surface of a source 231S of the reset transistor RST electrically coupled to the FD 121 and having the same node protrude from the surface 100S1 of the semiconductor layer 100S surrounding the upper surface of the source 231S.

Here, the semiconductor layer 100S corresponds to a specific example of a "first semiconductor layer" according to one embodiment of the present disclosure. The photodiode PD corresponds to a specific example of a "photoelectric converter" according to one embodiment of the present disclosure. The FD 121 corresponds to a specific example of a "floating diffusion layer" according to one embodiment of the present disclosure. The transfer transistor TR corresponds to a specific example of a "first transistor". The pixel circuit 210 corresponds to a specific example of a "pixel circuit" according to one embodiment of the present disclosure. The reset transistor corresponds to a specific example of a "second transistor" according to one embodiment of the present disclosure.

### [Specific Configuration of Imaging Device]

Similarly to the imaging device 1 of the first embodiment described above, the imaging device 2 includes repeated arrays of the pixel sharing units 539 each including a plurality of pixels 541, and the arrays are arranged in the row direction and the column direction. Each pixel sharing unit 539 includes four pixels 541. The four pixels each include a photodiode PD. The pixel sharing unit 539 is a unit that shares a single pixel circuit 210. A pixel signal is sequentially read from each of the four pixels 541 by operating the pixel circuit 210 in a time divisional manner. The four pixels 541 are arranged in two rows and two columns, for example. That is, in other words, the imaging device 2 includes the four pixels 541 and the pixel circuit 210 in each pixel sharing unit 539, as illustrated in FIG. 23, for example.

As illustrated in FIG. 23, for example, the FD 121 is provided at a central portion of the pixel sharing unit 539. The FD 121 includes monocrystal silicon formed by epitaxially growing the surface 100S1 of the semiconductor layer 100S in a selective manner, and part of the FD 121 protrudes from the surface 100S1 of the semiconductor layer 100S. In the FD 121, an n-type impurity such as phosphorous (P) or arsenic (As) is diffused. The FD 121 is in ohmic contact with a coupling wiring CS. Accordingly, the impurity concentration is high in the vicinity of a front surface of the FD 121 in contact with the coupling wiring CS. The FD 121 is electrically coupled to the gate of the amplification transistor AMP and the source of the reset transistor RST via an electric means such as the coupling wiring CS.

The transfer transistor TR is provided in each pixel 541. The transfer transistor TR includes a transfer gate TG. The transfer gate TG provided in each of the four pixels 541 is disposed close to the FD 121 to surround the FD 121 provided at the central portion of the pixel sharing unit 539. The gate insulating film 123 is provided between the semiconductor layer 100S and the transfer gate TG. Side surfaces of the transfer gate TG are covered with the side wall SW. The side wall SW includes, for example, silicon nitride (SiN).

As illustrated in FIG. 23, for example, the reset transistor RST, the amplification transistor AMP, and the selection transistor SEL are arranged in parallel in one direction (X-axis direction) in the vicinity of the four pixels 541 arranged in two rows and two columns. The reset transistor RST includes, for example, a gate 231G, a source 231S, and a drain 231D. The amplification transistor AMP includes, for example, a gate 232G, a source 232S, and a drain 232D. The selection transistor SEL includes, for example, a gate 233G, a source 233S, and a drain 233D. Out of the reset transistor RST, the amplification transistor AMP, and the selection transistor SEL, the reset transistor RST electrically coupled to the FD 121 and having the same node as the FD 121 has the source 231S that partially protrudes from the surface 100S1 of the semiconductor layer 100S, similarly to the FD 121.

In the vicinity of the surface 100S1 of the semiconductor layer 100S, the LDD region 118 is further provided. The LDD region 118 is an n-type semiconductor region provided within the p-well layer 115. The LDD region 118 is provided in each of the pixels 541. The LDD regions 118 provided in the four pixels 541 of the pixel sharing unit 539 are provided close to each other so as to be adjacent to the FD 121 provided in the central portion of the pixel sharing unit 539.

### [Method of Manufacturing Imaging Device]

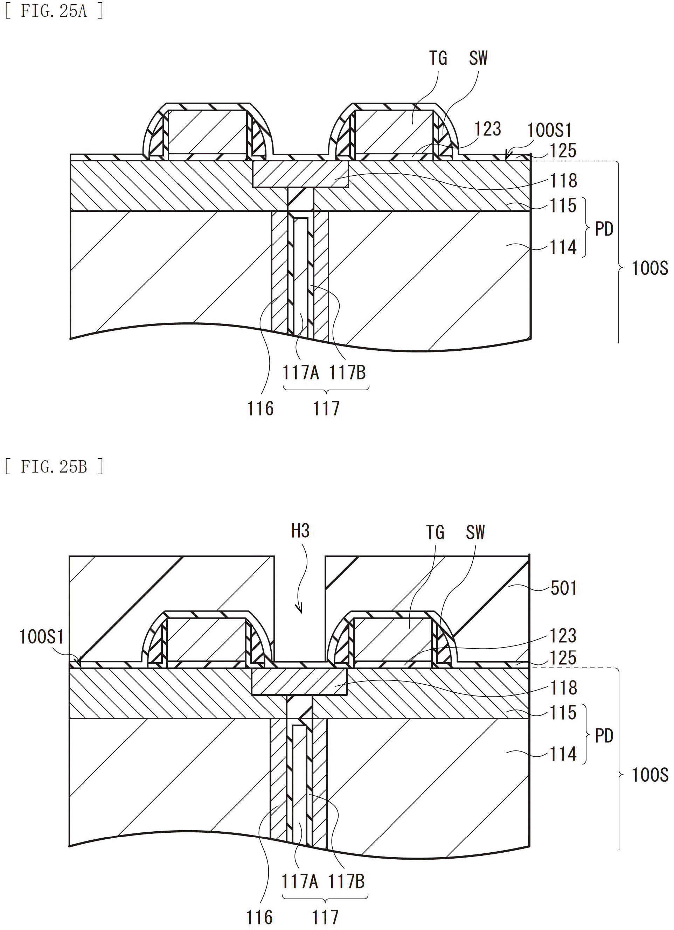

FIGs. 25A to 25F illustrate an exemplary method of manufacturing the imaging device 2 (in particular, the first substrate 100) illustrated in FIG. 22.

First, the pixel separation unit 117 or the like is formed as illustrated in FIG. 25A, and the LDD region 118, the transfer gate TG having side walls SW on side faces, and the passivation film 125 covering the surface 100S1 of the semiconductor layer 100S and the surface of the transfer gate TG are formed on the surface 100S1 of the semiconductor layer 100S.

Next, as illustrated in FIG. 25B, a photoresist pattern 501 is selectively formed. The photoresist pattern 501 has an opening H3 in a space between the transfer gates TG in which the FD 121 is to be formed, or, although not illustrated, at a position at which the source 231S of the reset transistor RST is to be formed.

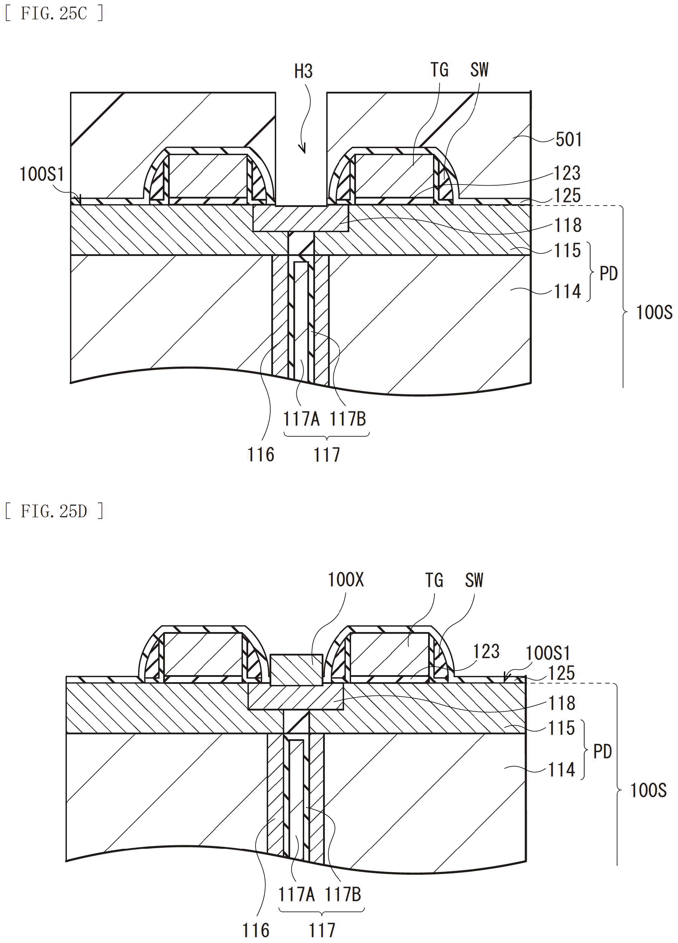

Thereafter, as illustrated in FIG. 25C, the passivation film 125 on a bottom of the opening H3 is selectively removed by etching (e.g., dry etching) using the photoresist pattern 501 as a mask to expose the semiconductor layer 100S.

Next, as illustrated in FIG. 25D, silicon is epitaxially grown selectively on the semiconductor layer 100S exposed at the bottom of the opening H3 to form a protrusion 100X. Thereafter, the photoresist pattern 501 is removed.

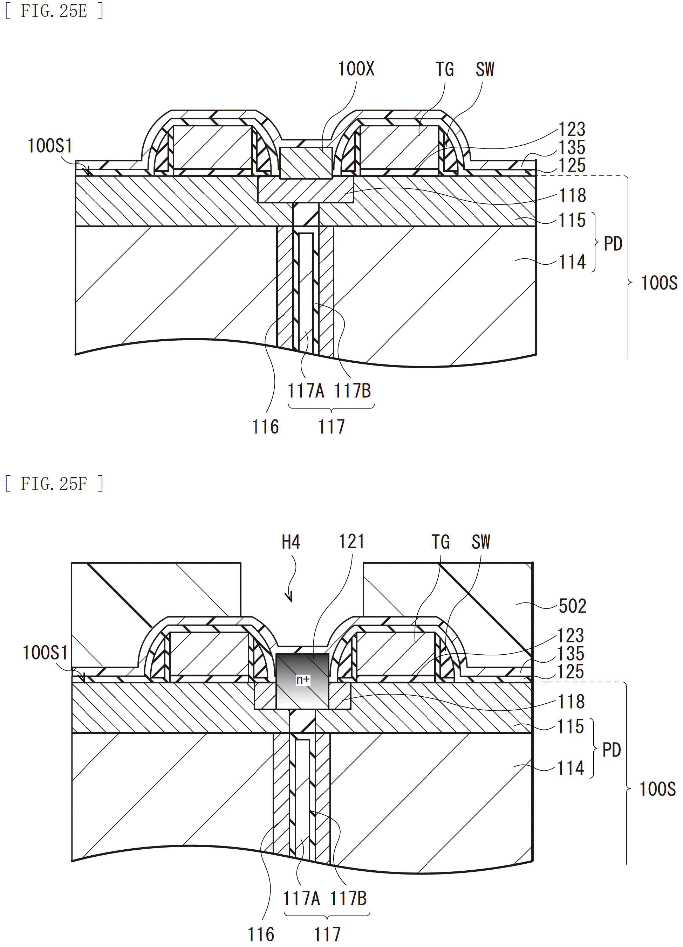

Thereafter, as illustrated in FIG. 25E, a sacrificial oxide film 135 is formed to cover a surface of the passivation film 125 and a surface of the protrusion 100X. The sacrificial oxide film 135 may be formed by a method such as atomic layer deposition (ALD).

Next, as illustrated in FIG. 25F, a photoresist pattern 502 is selectively formed. The photoresist pattern 502 has an opening H4 in a space between the transfer gates TG in which the FD 121 is to be formed, or, although not illustrated, at a position at which the source 231S of the reset transistor RST is to be formed. Thereafter, an n-type impurity is injected into the protrusion 100X by ion implantation to form an n-type impurity region (n+) having a higher impurity concentration than the other regions. Thereafter, the wiring layer 100T is formed. The first substrate 100 is thus completed.

### [Workings and Effects]

According to the imaging device 2 of the present embodiment, the FD 121 and the upper surface of the source 231S of the reset transistor RST electrically coupled to the FD 121 and having the same node as the FD 121 protrude from the surface 100S1 of the semiconductor layer 100S surrounding the FD 121 and the upper surface of the source 231S. This is described in the following.

As a technique to suppress a dark current of a CMOS image sensor, a technique is proposed that forms a p-type channel layer immediately below a gate electrode (transfer gate) of a transfer transistor by applying a negative voltage to the transfer gate and prevents a dark current from generating at the location. For example, a voltage of - 1.0 V is applied to the transfer gate to suppress a dark current.

However, an electric field between the floating diffusion (FD) and a lower end of the transfer gate close to the FD is locally strengthened, leading to an occurrence of leaks (FD white spots) in the FD. This eventually results in noises which decrease the image quality. The electric field around the FD is thus important in structural design. Therefore, measures such as placing an LDD region next to the transfer gate close to the FD have been implemented; however, as pixel sizes become finer, it has become difficult to secure a sufficiently wide LDD region. This makes it difficult to relax the electric field.

Further, the problem of the leak current from the electric field is applied not only to the FD surrounded by the transfer gates but also the reset transistor having the same node as the FD.

To address this, according to the present embodiment described above, the FD 121 and the upper surface of the source 231S of the reset transistor RST protrude from the surface 100S1 of the semiconductor layer 100S surrounding the FD 121 and the upper surface of the source 231S. This physically separates the FD 121 having a high impurity concentration from the end of the transfer gate TG and the upper surface of the source 131S of the reset transistor RST. This mitigates the electric field between the FD 121 and the transfer transistor TR and the electric field between the FD 121 and the source 131S of the reset transistor RST, and suppresses a dark current.

As described above, the imaging device 2 according to the present embodiment makes it possible to suppress an increase in FD white spots upon miniaturization of the pixels and thus to improve the reliability. It is therefore possible to provide a high-resolution imaging device having high reliability, for example.

### <4. Modification Examples>

### (4-1. Modification Example 2)

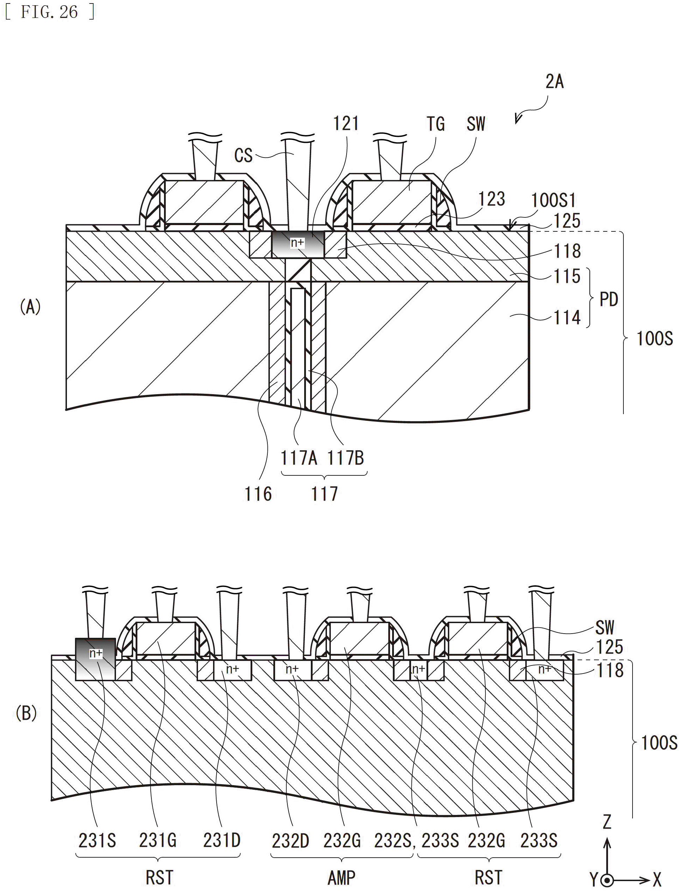

FIG. 26 schematically illustrates an exemplary cross-sectional configuration of the first substrate 100 of a light detecting device (e.g., an imaging device 2A) according to Modification Example 2 of the present disclosure. Part (A) of FIG. 26 illustrates an exemplary cross-sectional configuration of the vicinity of the front surface (surface 100S1) of the semiconductor layer 100S taken along a line III-III' illustrated in FIG. 23 the description of the second embodiment refers to. Part (B) of FIG. 26 illustrates an exemplary cross-sectional configuration of the vicinity of the front surface (surface 100S1) of the semiconductor layer 100S taken along a line IV-IV' illustrated in FIG. 23.

In the second embodiment, the FD 121 and the upper surface of the source 231S of the reset transistor RST protrude from the surface 100S1 of the semiconductor layer 100S surrounding the FD 121 and the upper surface of the source 231S; however, this is non-limiting. In the imaging device 2A of the present modification example, only the upper surface of the source 231S of the reset transistor RST projects from the surface 100S1 of the semiconductor layer 100S surrounding the upper surface. Except this point, the imaging device 2A has a substantially similar configuration to the imaging device 2 of the second embodiment described above.

The imaging device 2A of the present modification example having such a configuration makes it possible to provide effects similar to those of the imaging device 2 of the second embodiment described above.

### (4-2 Modification Example 3)

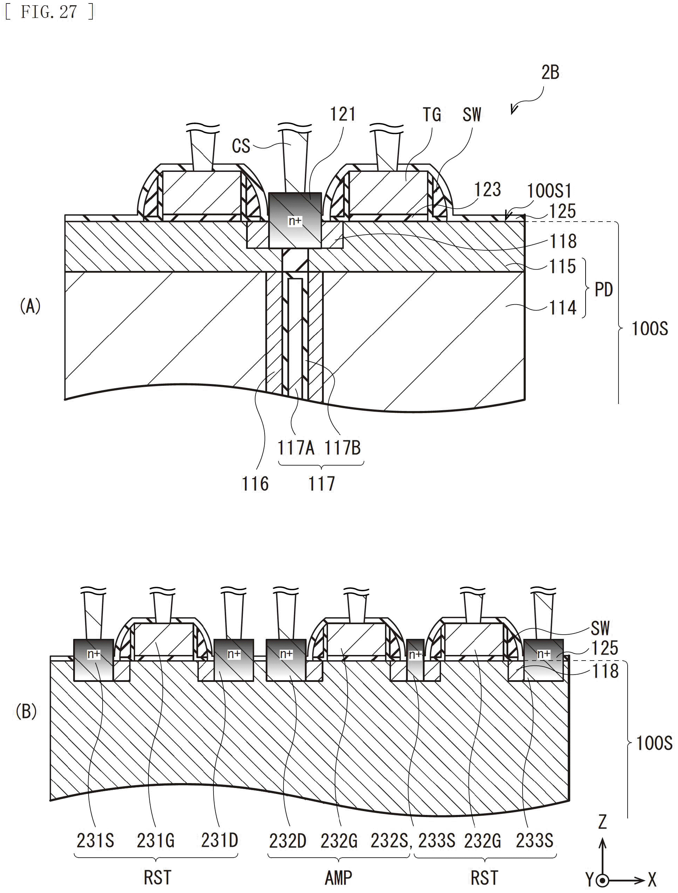

FIG. 27 schematically illustrates an exemplary cross-sectional configuration of the first substrate 100 of a light detecting device (e.g., an imaging device 2B) according to Modification Example 3 of the present disclosure. Part (A) of FIG. 27 illustrates an exemplary cross-sectional configuration of the vicinity of the front surface (surface 100S1) of the semiconductor layer 100S taken along the line III-III' in FIG. 23 the description of the second embodiment refers to. Part (B) of FIG. 27 illustrates an exemplary cross-sectional configuration of the vicinity of the front surface (surface 100S1) of the semiconductor layer 100S taken along the line IV-IV' illustrated in FG. 23.

In the second embodiment, the FD 121 and the upper surface of the source 231S of the reset transistor RST protrude from the surface 100S1 of the semiconductor layer 100S surrounding the FD 121 and the upper surface of the source 231S; however, this is non-limiting. In the imaging device 2B of the present modification example, the upper portion of the FD 121 and all of the upper surfaces of the sources 231S, 232S, and 233S and the drains 231D, 232D, and 233D of the reset transistor RST, the amplification transistor AMP, and the selection transistor SEL included in the pixel circuit 210 protrude from the surface 100S1 of the semiconductor layer 100S surrounding these portions. Except this point, the imaging device 2B has a substantially similar configuration as the imaging device 2 of the second embodiment described above.

According to the imaging device 2B of the present modification example, it is possible to suppress dark currents and prevent degradation of the transistor due to hot carriers. It is therefore possible for the present modification example to provide a high-resolution imaging device 2B having higher reliability than the imaging device 2 of the second embodiment described above.

### (4-3. Modification Example 4)

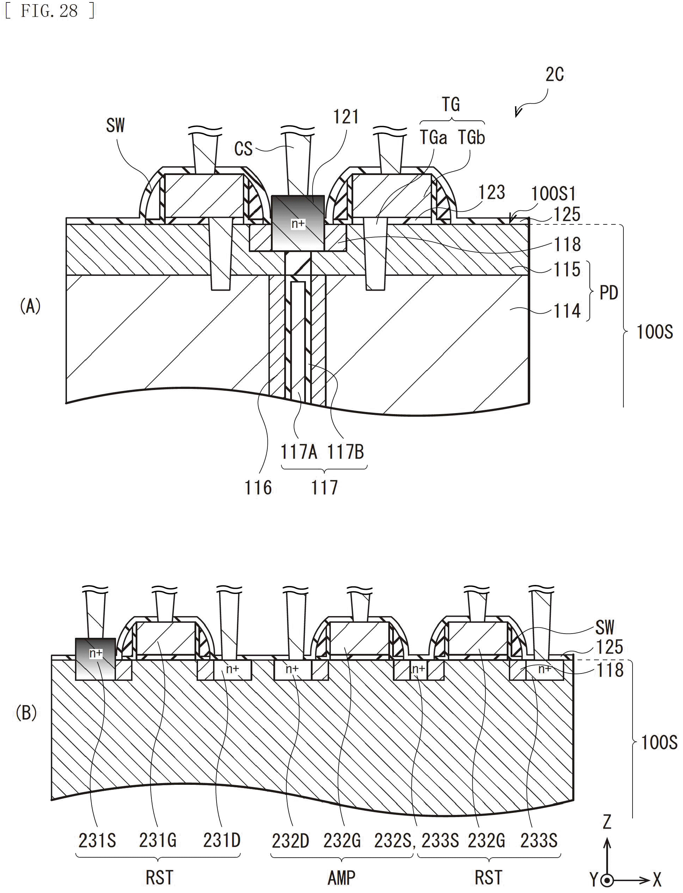

FIG. 28 schematically illustrates an exemplary cross-sectional configuration of the first substrate 100 of a light detecting device (e.g., an imaging device 2C) according to Modification Example 4 of the present disclosure. Part (A) of FIG. 28 illustrates an exemplary cross-sectional configuration of the vicinity of the front surface (surface 100S1) of the semiconductor layer 100S taken along the line III-III' illustrated in FIG. 23 the description of the second embodiment refers to. Part (B) of FIG. 28 illustrates an exemplary cross-sectional configuration of the vicinity of the front surface (surface 100S1) of the semiconductor layer 100S taken along the line IV-IV' illustrated in FIG. 23.

In the example described in the second embodiment, the transfer transistor TR is a so-called planar transistor; however, the transfer transistor TR may be a longitudinal transistor, as in the first embodiment described above. According to the imaging device 2C of the present modification example, the transfer transistor TR includes, for example, a horizontal portion TGb opposed to the front surface of the semiconductor layer 100S, and a vertical portion TGa provided within the semiconductor layer 100S. The vertical portion TGa extends in the thickness direction of the semiconductor layer 100S. The vertical portion TGa has one end in contact with the horizontal portion TGb, and another end provided in the n-type semiconductor region 114. Except this point, the imaging device 2C has a substantially similar configuration to the imaging device 2 of the second embodiment.

The imaging device 2C of the present modification example having such a configuration makes it possible to provide effects similar to those of the imaging device 2 of the second embodiment described above.

### (4-4. Modification Example 5)

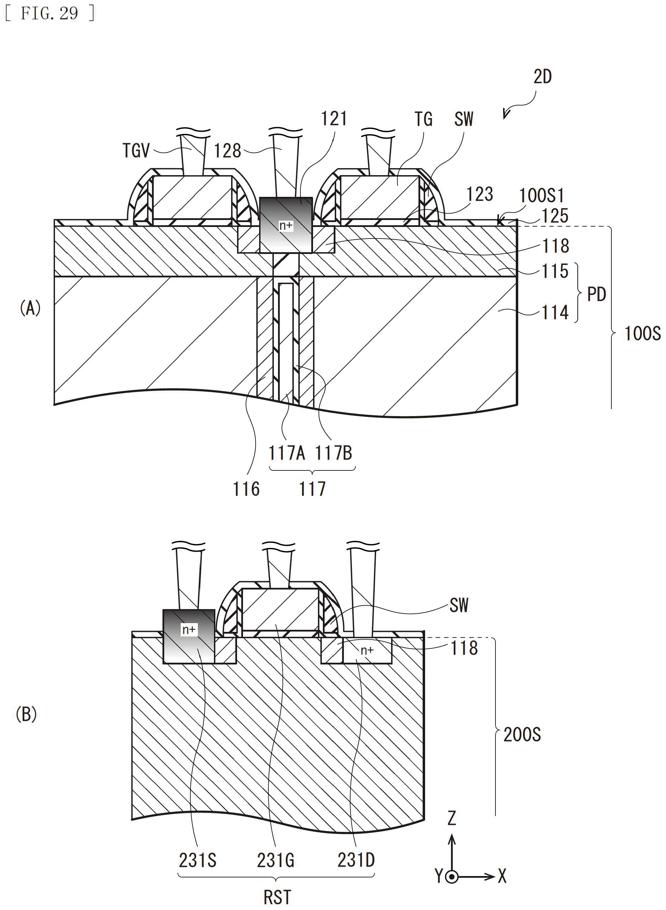

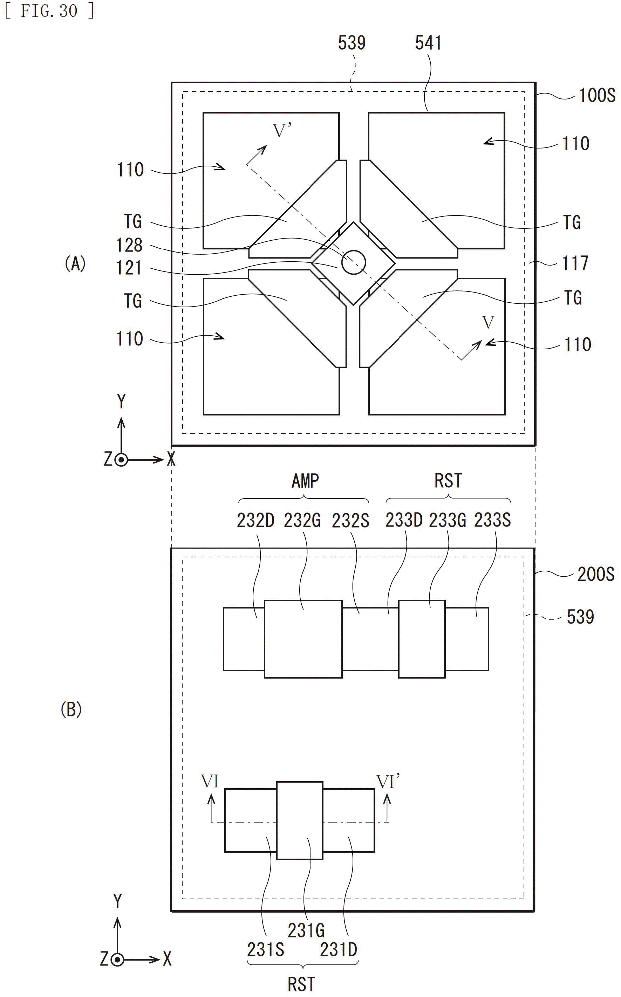

FIG. 29 schematically illustrates an exemplary cross-sectional configuration of the first substrate 100 of a light detecting device (e.g., an imaging device 2D) according to Modification Example 5 of the present disclosure. FIG. 30 schematically illustrates an exemplary planar layout of the pixel sharing unit 539 of the imaging device 2D. Part (A) of FIG. 29 illustrates an exemplary cross-sectional configuration of the vicinity of the front surface (surface 100S1) of the semiconductor layer 100S taken along a line V-V' illustrated in FIG. 30 the description of the second embodiment refers to. Part (B) of FIG. 29 illustrates an exemplary cross-sectional configuration of the vicinity of the front surface (surface 100S1) of the semiconductor layer 100S taken along a line VI-VI' illustrated in FIG. 30.

In the example of the second embodiment described above, the photodiode PD, the floating diffusion (FD)121, the transfer transistor TR, and the pixel circuit 210 are provided on one semiconductor substrate (semiconductor layer 100S); however, this is non-limiting. According to the imaging device 2D of the present modification example, the photodiode PD, the floating diffusion (FD) 121, and the transfer transistor TR are provided on the semiconductor layer 100S, and the pixel circuit 210 is provided on the semiconductor layer 200S, as in the first embodiment. That is, the imaging device 2D is an imaging device having a three-dimensional structure in which the three substrates (the first substrate 100, the second substrate 200, and the third substrate 300) are bonded to each other, for example. Except this point, the imaging device 2D has a substantially similar configuration to the imaging device 2 of the second embodiment.

The imaging device 2D of the present modification example having such a configuration makes it possible to provide effects similar to those of the imaging device 2 of the second embodiment.

### (4-5. Modification Example 6)

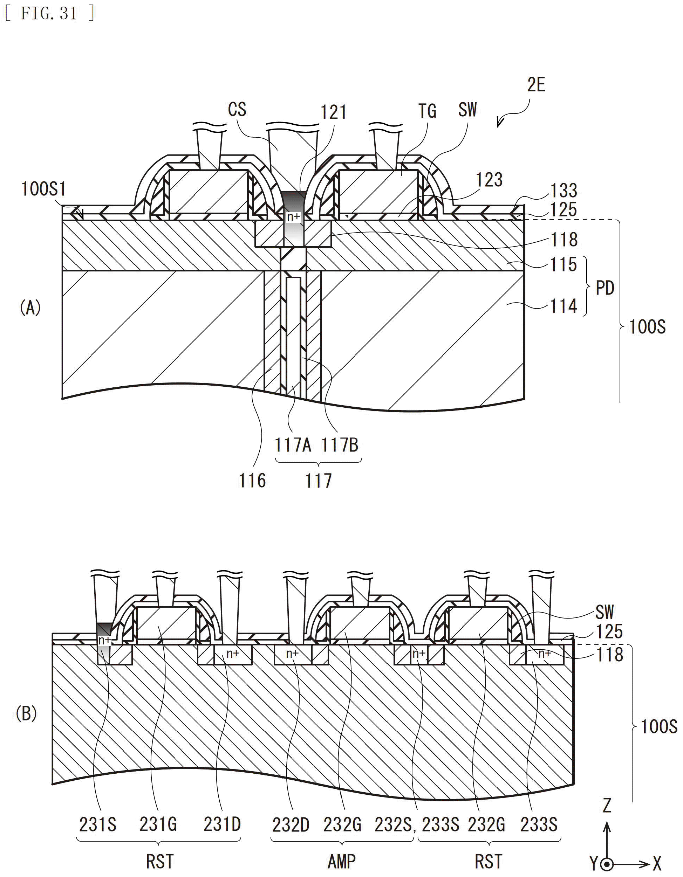

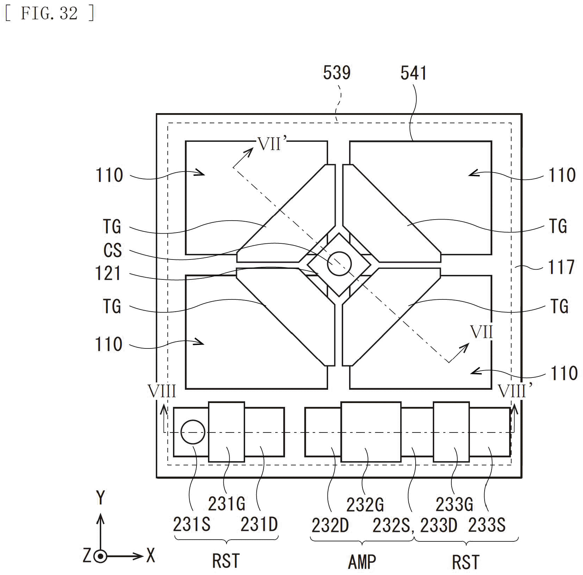

FIG. 31 schematically illustrates an exemplary cross-sectional configuration of the first substrate 100 of a light detecting device (e.g., an imaging device 2E) according to Modification Example 6 of the present disclosure. FIG. 32 schematically illustrates an exemplary planar layout of the pixel sharing unit 539 of the imaging device 2E. Part (A) of FIG. 31 illustrates an exemplary cross-sectional configuration of the vicinity of the front surface (surface 100S1) of the semiconductor layer 100S taken along a line VII-VII' illustrated in FIG. 32 the description of the second embodiment refers to. Part (B) of FIG. 31 illustrates an exemplary cross-sectional configuration of the vicinity of the front surface (surface 100S1) of the semiconductor layer 100S taken along a line VIII-VIII' illustrated in FIG. 32.

In the imaging device 2E of the present modification example, only a coupling part of the FD 121 with the coupling wiring CS protrudes.

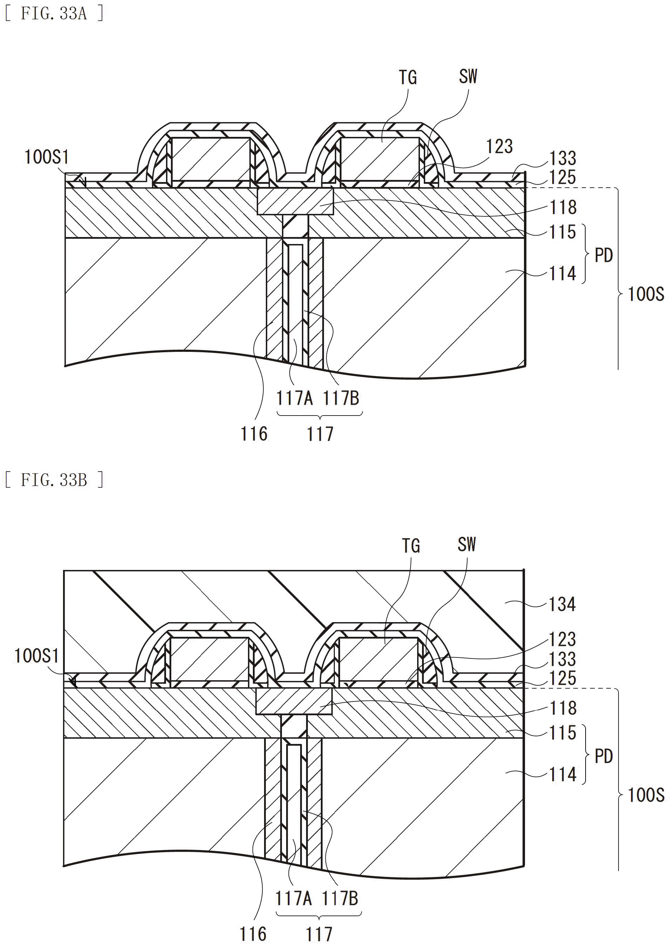

FIGs. 33A to 33E illustrate an exemplary method of manufacturing the imaging device 2E, in particular, the first substrate 100, illustrated in FIG. 22.

First, the pixel separation unit 117 and the like are formed, as illustrated in FIG. 33A. Thereafter, the LDD region 118, the transfer gate TG having the side wall SW on each side face, and the insulating film 133 covering the surface 100S1 of the semiconductor layer 100S and the front surface of the transfer gate TG are formed on the surface 100S1 of the semiconductor layer 100S.

Next, as illustrated in FIG. 33B, an oxide film 134 is formed on the insulating film 133, following which a front surface of the oxide film 134 is polished and flattened by chemical mechanical polishing (CMP).

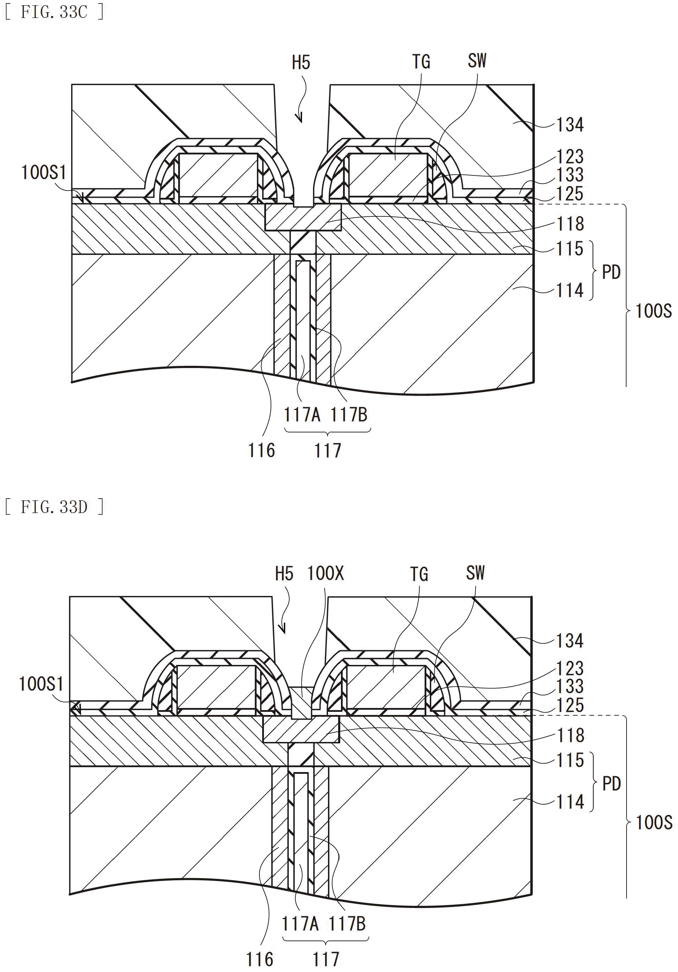

Thereafter, as illustrated in FIG. 33C, an opening H5 is formed by selectively removing the passivation film 125, the insulating film 133, and the oxide film 134 in a space between the transfer gates TG in which the D121 is to be formed, by a photolithographic technology, for example.

Thereafter, as illustrated in FIG. 33D, silicon is epitaxially grown selectively on the semiconductor layer 100S exposed at a bottom portion of the opening H5 to form the protrusion 100X.

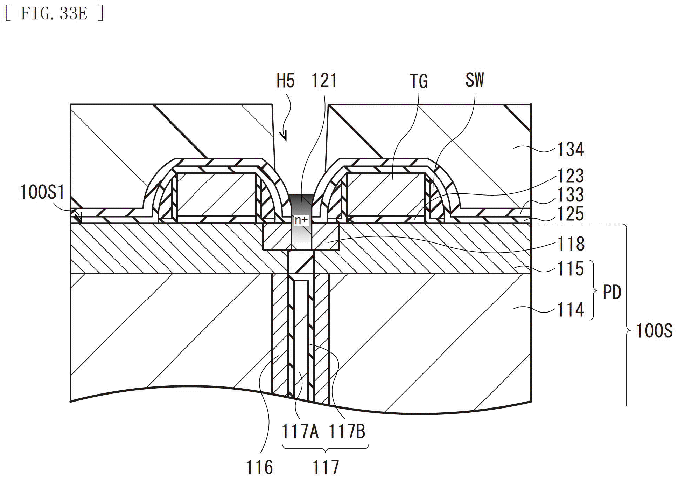

Thereafter, as illustrated in FIG. 33E, an n-type impurity is injected into the protrusion 100X by ion implantation to form an n-type impurity region (n+) having a higher impurity concentration than the other regions. Thereafter, the coupling wiring CS is formed by burying polysilicon in the opening H5, for example. The first substrate 100 illustrated in FIG. 31 is thus completed.

According to the imaging device 2E of the present modification example described above, the protrusion 100X and the coupling wiring CS are sequentially formed after the opening H5 in which the coupling wiring CS is to be formed is formed. This makes it possible to form an opening for coupling between the FD 121 and the coupling wiring CS in a self-aligning manner. It is therefore possible to achieve miniaturization of a pixel as compared with the second embodiment described above and to simplify the manufacturing steps.

### <5. Third Embodiment>

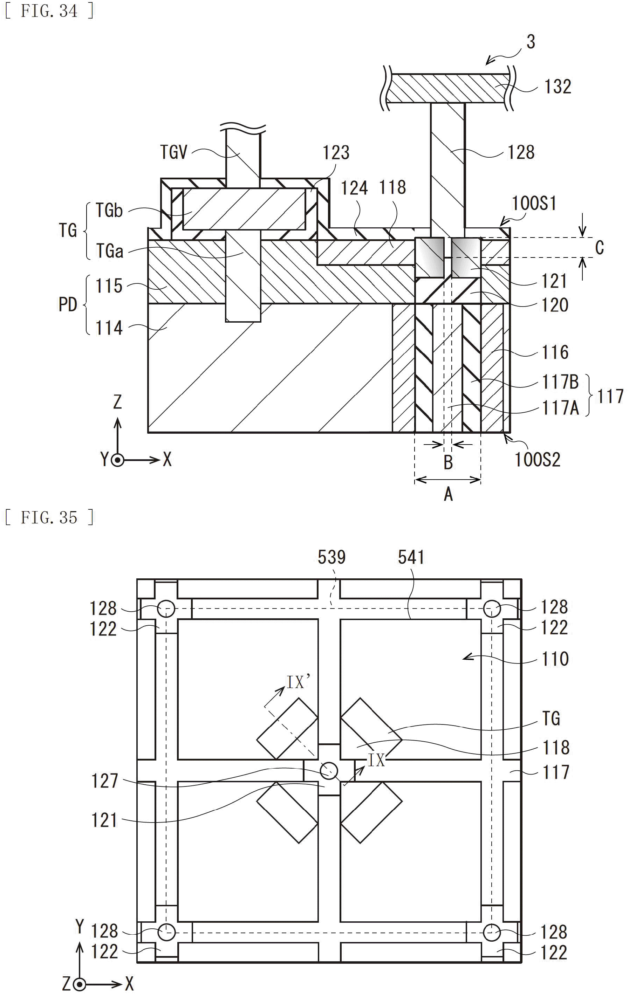

FIG. 34 schematically illustrates an exemplary cross-sectional configuration of the vicinity of the front surface (surface 100S1) of the semiconductor layer 100S included in the first substrate 100 of a light detecting device (e.g., an imaging device 3) according to a third embodiment of the present disclosure. FIG. 35 schematically illustrates an exemplary planar layout of the pixel sharing unit 539 of the imaging device 3. FIG. 34 illustrates an exemplary cross-sectional configuration of the vicinity of the front surface (surface 100S1) of the semiconductor layer 100S taken along a line IX-IX' illustrated in FIG. 35.

### [Specific Configuration of Imaging Device]

The imaging device 3 of the present embodiment includes the first substrate 100, the second substrate 200, and the third substrate 300 stacked in this order, similarly to the imaging device 1 of the first embodiment. For example, the imaging device 3 is an imaging device of a rear surface irradiation type.

As in the first embodiment, the semiconductor layer 100S includes, for example, the p-well layer 115 on a part of the front surface (the surface 100S1 close to the wiring layer 100T) or in the vicinity of thereof, and includes the n-type semiconductor region 114 in another region (a region deeper than the p-well layer 115). For example, the n-type semiconductor region 114 and the p-well layer 115 constitute the p-n junction photodiode PD. The p-well layer 115 is a p-type semiconductor region.

As in the first embodiment described above, the floating diffusion (FD) 121, the VSS contact 122, the LDD region 118, the VSS contact region 119, and the transfer transistor TR are provided in the vicinity of the surface 100S1 of the semiconductor layer 100S.

The FD 121 and the VSS contact 122 are provided at or near an intersection of the four pixels 541 arranged in two rows and two columns above the pixel separation unit 117. Specifically, the FD 121 is provided at a central portion of the pixel sharing unit 539, and the VSS contact 122 is provided at each of the four corners of the pixel sharing unit 539. The LDD region 118 is an n-type semiconductor region provided in the p-well layer 115. The VSS contact region 119 is, for example, a p-type semiconductor region. The LDD region 118 is provided in each of the pixels 541. The LDD regions 118 provided in the respective pixels 541A, 541B, 541C, and 541D of the pixel sharing unit 539 are provided close to each other so as to be adjacent to the FD 121 provided in the central portion of the pixel sharing unit 539. The VSS contact region 119 is provided separately from the LDD region 118. For example, the LDD region 118 is provided at one end of each of the pixels 541A, 541B, 541C, and 541D in the V-direction, and the VSS contact region 119 is provided at another end of the pixel. The VSS contact region 119 is provided adjacent to the VSS contact 122, allowing the semiconductor layer 100S to be supplied with a reference potential.

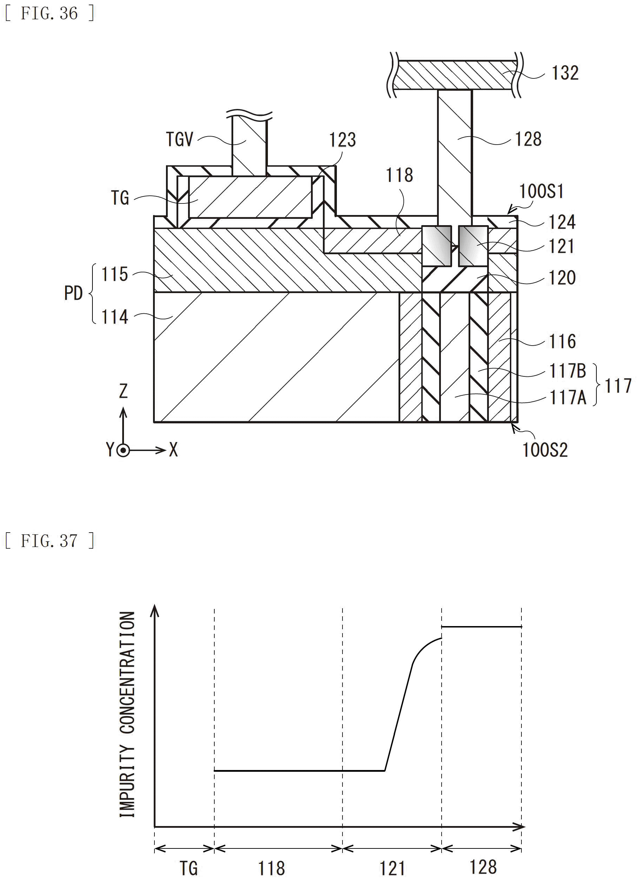

The transfer transistor TR includes the transfer gate TG. The transfer gate TG includes, for example, the horizontal portion TGb opposed to the front surface of the semiconductor layer 100S, and the vertical portion TGa provided inside the semiconductor layer 100S. The vertical portion TGa extends in a thickness direction of the semiconductor layer 100S. One end of the vertical portion TGa is in contact with the horizontal portion TGb, and the other end is provided inside the n-type semiconductor region 114. The transfer transistor TR configured by such a longitudinal transistor makes it possible to substantially prevent a transfer failure of a pixel signal and to improve efficiency in reading the pixel signal. It is to be noted that, as illustrated in FIG. 36, the transfer transistor TR may be a planar transistor.

The FD 121 includes monocrystal silicon buried in the vicinity of the front surface (surface 100S1) of the semiconductor layer 100S, and a part of the FD 121 protrudes from the surface 100S1 of the semiconductor layer 100S. As in the first embodiment, the through-electrode 128 is directly coupled to the FD 121, and an n-type impurity such as phosphorus (P) or arsenic (As) derived from the through-electrode 128 is diffused in the monocrystal silicon of the FD 121. In the present embodiment, the FD 121 is arranged at a central portion of the pixel sharing unit 539, and the pixels 541A, 541B, 541C, and 541D of the pixel sharing unit 539 have respective boundaries adjacent to each other with a gap provided therebetween.

The gap has a width B narrower than a width A of the insulating film 120 buried between the pixel separation unit 117 and the FD 121, and the insulating film 120 is buried in the gap. Further, the through-electrode 128 directedly coupled to the FD 121 is buried in the gap. The through-electrode 128 buried in the semiconductor layer 100S has a depth C shallower than the FD 121 buried in the semiconductor layer 100S. That is, the insulating film 120 and the through-electrode 128 are buried in the gap of the FD 121.

It is to be noted that the structure of the FD 121 described above is applicable to the VSS contact 122.

FIG. 37 is a concentration profile of the n-type impurity included in the transfer gate TG, the LDD region 118, the FD 121, and the through-electrode 128. In the present embodiment, the through-electrode 128 is buried in the gap of the FD 121 as described above. Thus, the impurity diffused from the wiring layer 132 to the through-electrode 128 diffuses inside the FD 121 through the upper surface and the side surfaces of the FD 121 in contact with the through-electrode 128. Accordingly, as illustrated in FIG. 37, an impurity concentration gradient in which the concentration of the n-type impurity gradually decreases from the through-electrode 128 toward the transfer gate TG is formed, and it is possible to expand a distance between the transfer gate TG and a bottom of the gradient, as compared with the concentration profile of the n-type impurity included in the transfer gate TG, the LDD region 118, the FD 121, and the through-electrode 128 of the first embodiment. In other words, it is possible to reduce the diffusion range of the impurity inside the FD 121. This makes it possible to decrease the FD capacitance.

### [Method of Manufacturing Imaging Device]

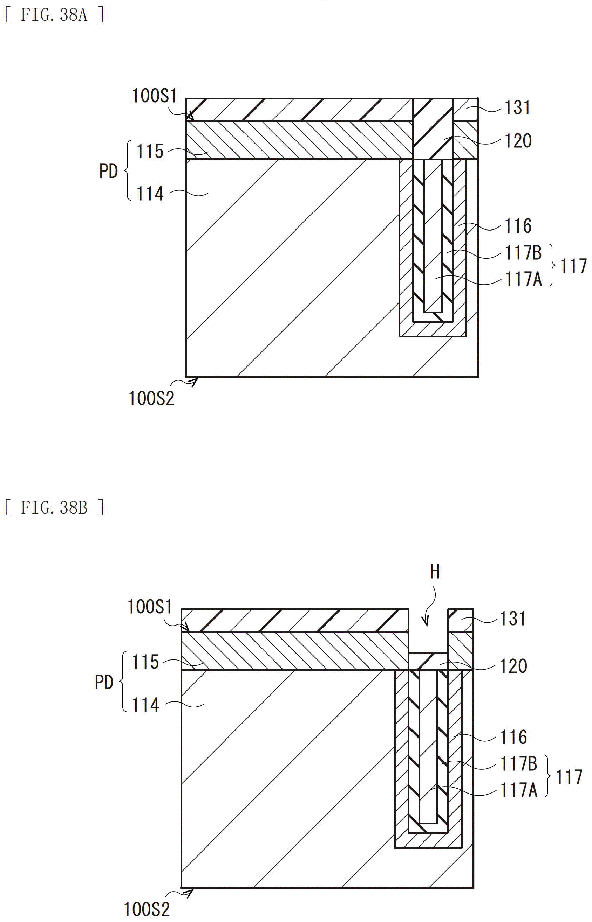

FIGs. 38A to FIG. 38I illustrate an exemplary method of manufacturing the imaging device 1 (in particular, the first substrate 100) illustrated in FIG. 1.

First, as in the first embodiment described above, the pixel separation unit 117 is formed on the surface 100S1 of the semiconductor layer 100S, and the mask 131 is patterned on the surface 100S1 of the semiconductor layer 100S. Thereafter, as illustrated in FIG. 38A, the insulating film 120 is buried above the pixel separation unit 17.

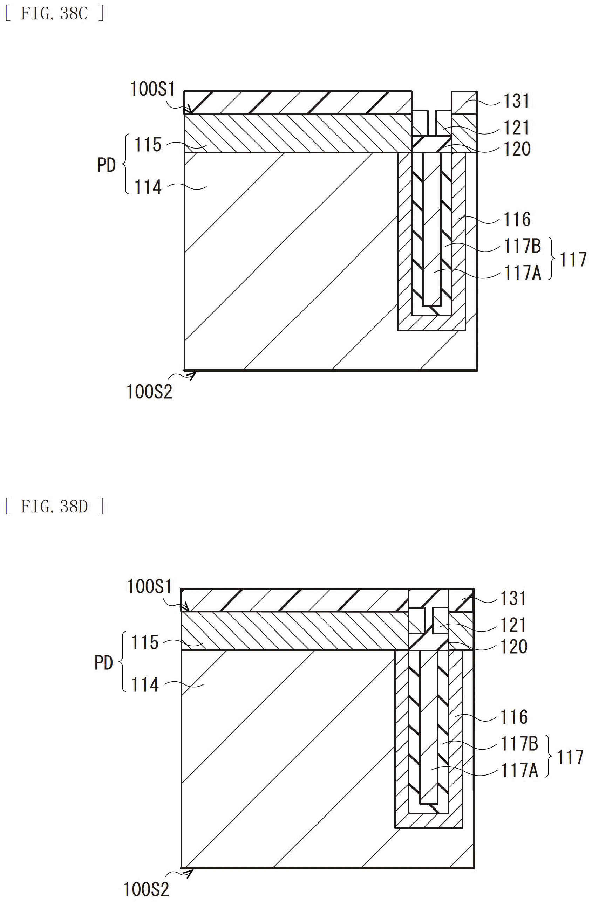

Next, as illustrated in FIG. 38B, for example, the insulating film 120 is partially etched to form the opening H, and the silicon substrate is exposed at side faces of the opening H. Thereafter, as illustrated in FIG. 38C, the silicon is epitaxially grown selectively on the side surfaces of the opening H to form the FD 121 including monocrystal silicon. At this time, the silicon portions growing from the side surfaces of the opening H are stopped from growing before coming into contact with each other to form a gap therebetween.

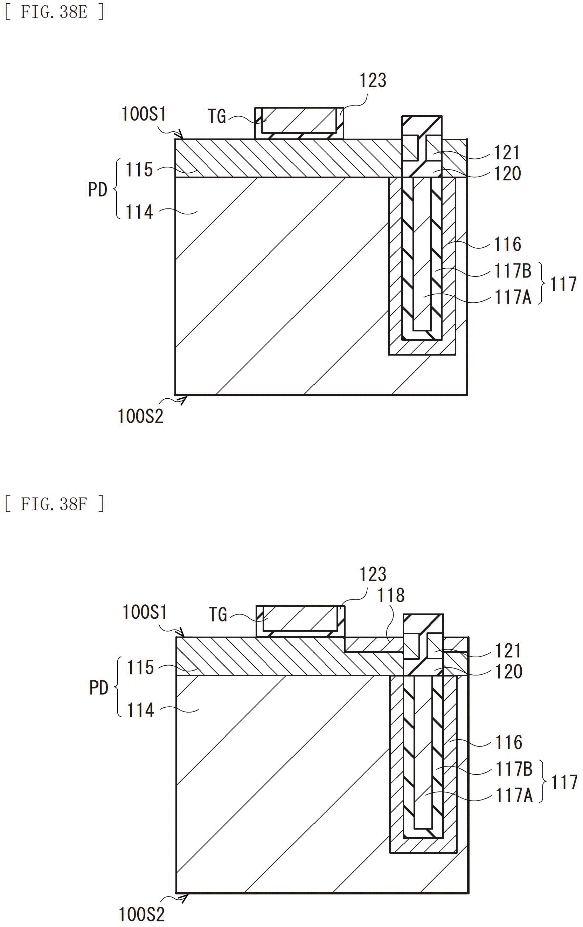

Next, as illustrated in FIG. 38D, the insulating film 120 is formed to fill the gap, following which the insulating film 120 formed on the mask 131 is removed by the CMP. After the mask 131 is removed, as illustrated in FIG. 38E, the gate insulating film 123 and the transfer gate TG are formed on the surface 100S1 of the semiconductor layer 100S.

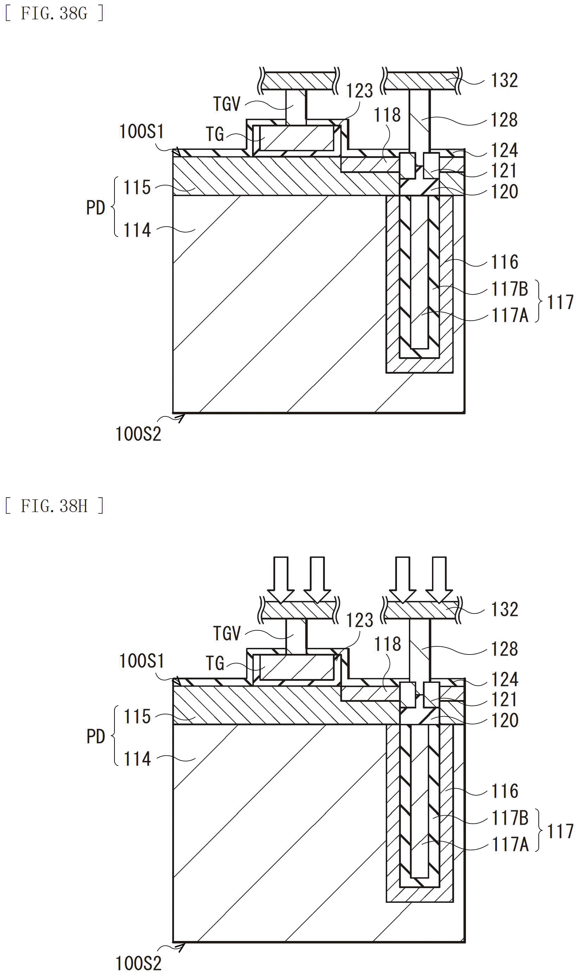

Next, as illustrated in FIG. 38F, an impurity is diffused between the FD 121 and the transfer gate TG and into the FD 121 by ion implantation, for example, to form the LDD region 118. Thereafter, the interlayer insulating film 124 and the like are formed, following which the through-electrode 128 and the through-electrode TGV including polysilicon are formed as illustrated in FIG. 38G. Further, a wiring including, for example, polysilicon (e.g., the wiring layer 132) is formed.

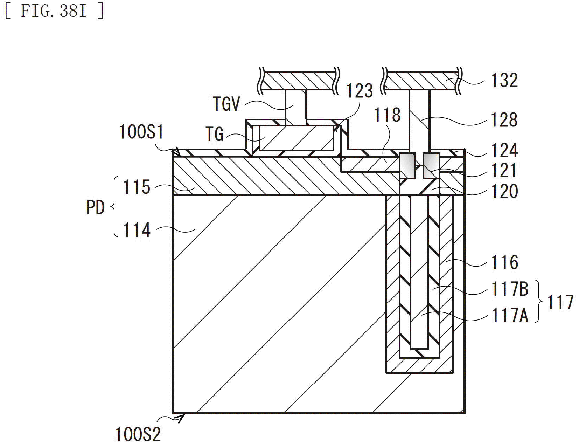

Next, as illustrated in FIG. 38H, an impurity is injected into the wiring layer 132 by ion implantation. Next, as illustrated in FIG. 38I, the impurity injected in the wiring layer 132 is diffused by thermal diffusion. In this way, the impurity concentration gradient in which the concentration of the impurity gradually decreases in order of the through-electrode 128, the FD 121, and the LDD region 118 is formed as illustrated in FIG. 37.

The concentration of the impurity included in the LDD region 118, the FD 121, and the through-electrode 128 and the impurity concentration gradient may be measured by, for example, scanning spread resistance microscopy (SSRM) or scanning microwave impedance microscopy (sMIM).

### [Workings and Effects]

According to the imaging device 3 of the present embodiment, the FD 121 including monocrystal silicon and having the gap in the extending direction of the through-electrode 128 is buried above the pixel separation unit 17, and the through-electrode 128 is buried in the gap of the FD 121, for example. This makes it possible to form the impurity concentration gradient in which the concentration of the contained n-type impurity gradually decreases from the through-electrode 128 to the transfer gate TG, and to reduce the diffusion range of the impurity inside the FD 121.

According to the imaging device 3 of the present embodiment, it is possible to reduce the FD capacity. This makes it possible to further improve the reliability.

### <6. Modification Example 7>

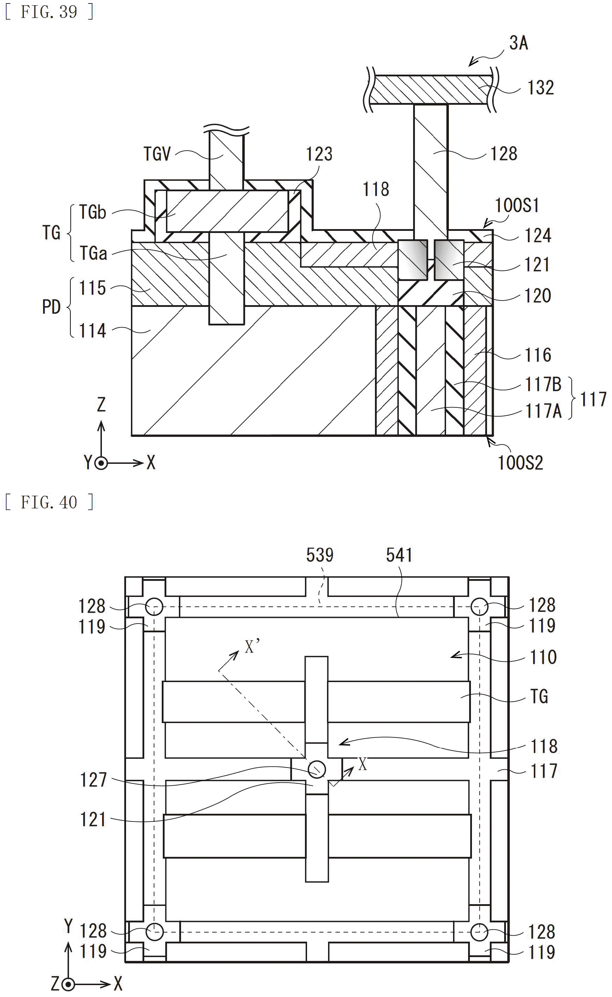

FIG. 39 schematically illustrates an exemplary cross-sectional configuration of the vicinity of the front surface (surface 100S1) of the semiconductor layer 100S included in the first substrate 100 of a light detecting device (e.g., an imaging device 3A) according to Modification Example 7 of the present disclosure. FIG. 40 schematically illustrates an exemplary planar layout of the pixel sharing unit 539 in the first substrate 100 of the imaging device 3A having a circuit configuration illustrated in FIG. 39. FIG. 39 schematically illustrates an exemplary cross-sectional configuration of the vicinity of the front surface (surface 100S1) of the semiconductor layer 100S taken along a line X-X' illustrated in FIG. 40.

The technology is applicable to an imaging device configured to acquire image data and parallax data at the same time.

In the imaging device 3A, the multiple pixels 541 configured to acquire the image data and the parallax data at the same time are arranged in a matrix in the pixel array unit 100A. In the imaging device 3A, out of the four pixels (pixels 543A, 541B, 541C, and 541D) arranged in two rows and two columns in the pixel sharing unit 539, the pixel separation unit 117 extending in the Y-axis direction between the pixels adjacent to each other in the X-axis direction is separated from the pixel separation unit 117 extending in the X-axis direction, and electric charges are movable between the pixels adjacent to each other in the X-axis direction.

The transfer transistor TR includes the transfer gate TG. As illustrated in FIG. 40, for example, the transfer gate TG is provided between the pixel separation units 117 opposed to each other in the X-axis direction. The transfer gate TG has the horizontal portion TGb opposed to the front surface of the semiconductor layer 100S and the vertical portion TGa provided inside the semiconductor layer 100S. The vertical portion TGa extends in the thickness direction of the semiconductor layer 100S. One end of the vertical portion TGa is in contact with the horizontal portion TGb, and another end is provided inside the n-type semiconductor region 114. The transfer transistor TR configured by such a longitudinal transistor makes it possible to substantially prevent a transfer failure of a pixel signal and to improve efficiency in reading the pixel signal. The transfer transistor TR may be a planar transistor.

The imaging device 3A of the present modification example having such a configuration makes it possible to provide effects similar to those of the third embodiment described above.

### <7. Application Examples>

### (Application Example 1)

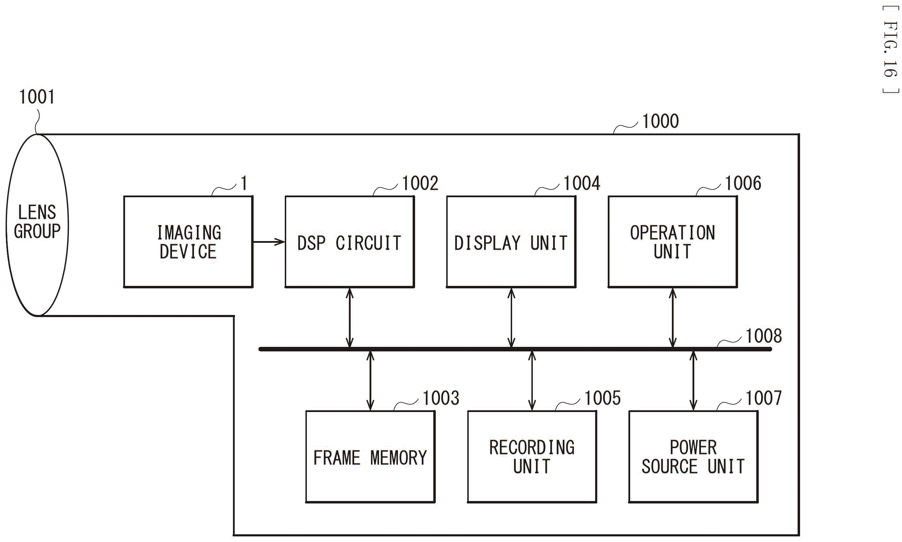

The light detecting device of the present disclosure (e.g., the imaging device 1) is applicable to various types of electronic apparatuses with an imaging function, such as a camera system or a mobile phone with an imaging function. Examples of the camera system include a digital still camera and a video camera. FIG. 16 schematically illustrates an outline configuration of an electronic apparatus 1000.

The electronic apparatus 1000 includes, for example, a lens group 1001, the imaging device 1, a digital signal processor (DSP) circuit 1002, a frame memory 1003, a display unit 1004, a recording unit 1005, an operation unit 1006, and a power source unit 1007 that are coupled to each other via a bus line 1008.

The lens group 1001 incorporates incident light (image light) from a subject and collects the light on an imaging surface of the imaging device 1. The imaging device 1 converts a light amount of the incident light collected on the imaging surface by the lens group 1001 into an electric signal per pixel, and supplies the electric signal as a pixel signal to the DPS circuit 1002.

The DSP circuit 1002 is a processing circuit that processes the signals supplied from the imaging device 1. The DSP circuit 1002 outputs image data obtained by processing the signals from the imaging device 1. The frame memory 1003 temporarily holds the image data processed by the DSP circuit 1002 per frame.

The display unit 1004 is, for example, a panel-type display apparatus such as a liquid crystal panel or an organic electroluminescence (EL) panel. The display unit 1004 records image data on a moving image or a still image captured by the imaging device 1 in a recording medium such as a semiconductor memory or a hard disc.

The operation unit 1006 outputs operations signals regarding various functions owned by the electronic apparatus 1000 in accordance with a user's operation. The power source unit 1007 supplies various kinds of power sources serving as operation power sources of the DSP circuit 1002, the frame memory 1003, the display unit 1004, the recording unit 1005, and the operation unit 1006 to these supply targets, as appropriate.

### (Application Example 2)

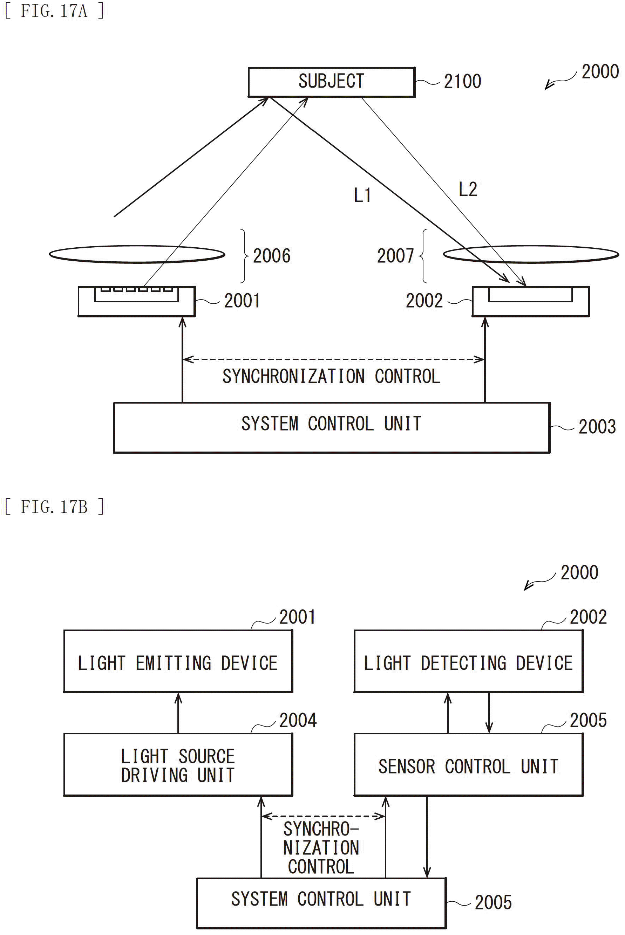

FIG. 17A schematically illustrates an exemplary overall configuration of a light detecting system 2000 including the light detecting device of the present disclosure (a light detecting device 2002). FIG. 17B illustrates an exemplary circuit configuration of the light detecting system 2000. The light detecting system 2000 includes a light emitting device 2001 as a light source unit that emits infrared light L2, and a light detecting device 2002 as a light receiving unit including a photoelectrical conversion element. As the light detecting device 2002, the imaging device 1 described above may be used. The light detecting system 2000 may further include a system control unit 2003, a light source driving unit 2004, a sensor control unit 2005, a light-source-side optical system 2006, and a camera-side optical system 2007.

The light detecting device 2002 is configured to detect light L1 and light L2. The light L1 is outside environment light reflected by a subject (measurement target object) 2100 (FIG. 17A). The light L2 is light emitted from the light emitting device 2001 and thereafter reflected by the subject 2100. The light L1 is, for example, visible light, and the light L2 is, for example, infrared light. The light L1 is detectable by a photoelectrical conversion unit in the light detecting device 2002, and the light L2 is detectable in a photoelectrical conversion region in the light detecting device 2002. Image information on the subject 2100 is obtainable from the light L1, and distance information between the subject 2100 and the light detecting system 2000 is obtainable from the light L2. The light detecting system 2000 is mountable on electronic devices such as smart phones or mobile bodies such as vehicles, for example. The light emitting device 2001 is configured by, for example, a semiconductor laser, a plane emitting semiconductor laser, or a vertical cavity surface emitting laser (VCSEL). The light detecting device 2002 may detect the light L2 emitted from the light emitting device 2001 by a detection method such as an iTOF method; however, this is non-limiting. In the iTOF method, the photoelectrically conversion unit may measure a distance to the subject 2100, based on, for example, time-of flight (TOF). The light detecting device 2002 may detect the light L2 emitted from the light emitting device 2001 by a detection method such as a structured light method or a stereo-vision method. In the structured light method, for example, the distance between the light detecting system 2000 and the subject 2100 may be detected by projecting light of a predetermined pattern on the subject 2100 and analyzing a distortion degree of the pattern. In the stereo-vision method, the distance between the light detecting system 2000 and the subject may be measured by acquiring two or more images seen from two or more points of view different from each other using two or more cameras, for example. It is to be noted that the light emitting device 2001 and the light detecting device 2002 may be controlled by the system control unit 2003 in a synchronization manner.

### <4. Practical Examples>

### (Practical Example to Endoscopic Surgery System)

The technology according to the present disclosure (present technology) is applicable to a variety of products. For example, the technology according to the present disclosure may be applied to an endoscopic surgery system.

FIG. 1011 is a view depicting an example of a schematic configuration of an endoscopic surgery system to which the technology according to an embodiment of the present disclosure (present technology) can be applied.

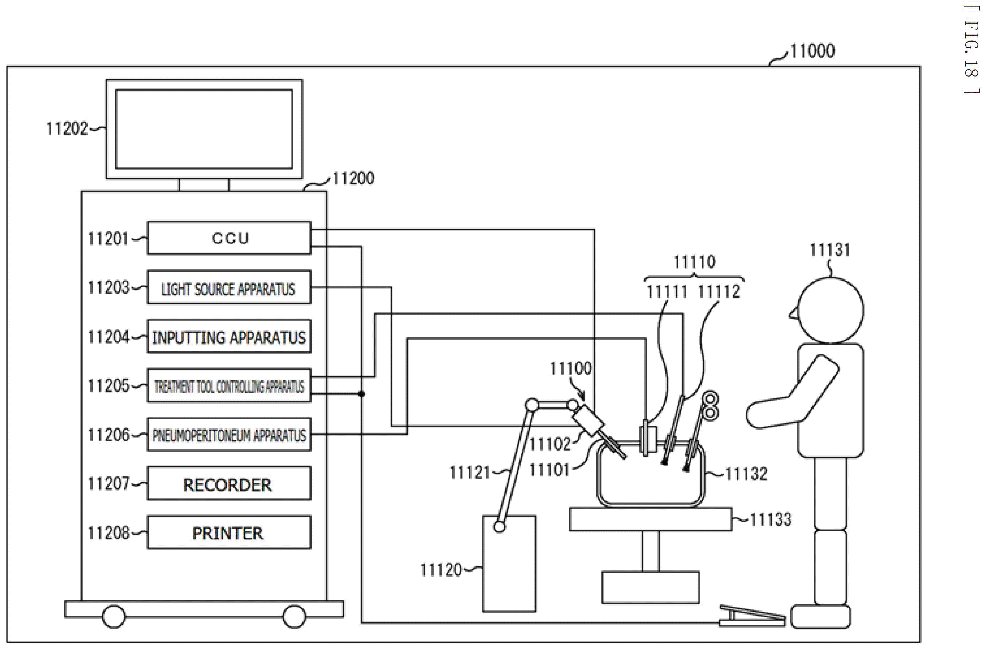

In FIG. 18, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

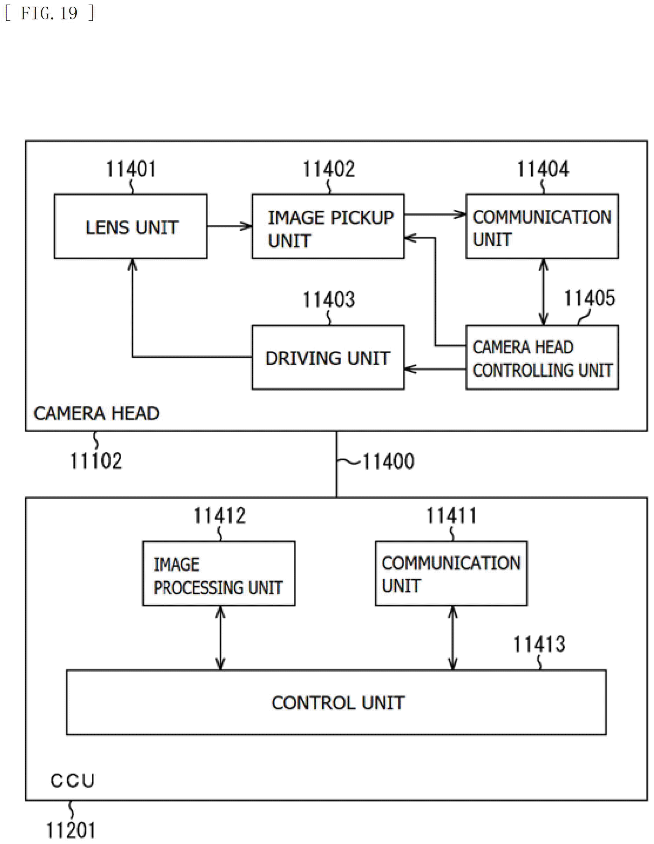

FIG. 19 is a block diagram depicting an example of a functional configuration of the camera head 11102 and the CCU 11201 depicted in FIG. 18.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The example of the endoscopic surgery system to which the technology according to the present disclosure is applicable has been described above. The technology according to the present disclosure is preferably applied to the image pickup unit 11402 out of the configurations described above. Applying the technology according to the present disclosure to the image pickup unit 11402 makes it possible to improve detection accuracy.

It is to be noted that, although the endoscopic surgery system is described herein as an example, the technology according to the present disclosure may be applied to another system such as a microscopic surgery system.

### (Practical Example to Mobile Bodies)

The technology (the present technology) according to the present disclosure is applicable to a variety of products. For example, the technology according to the present disclosure may be achieved as a device mountable on any type of mobile body such as an automobile, an electric vehicle, a hybrid electric vehicle, a motorcycle, a bicycle, a personal mobility, an aircraft, a drone, a vessel, a robot, a construction machine, or an agriculture machine (tractor).

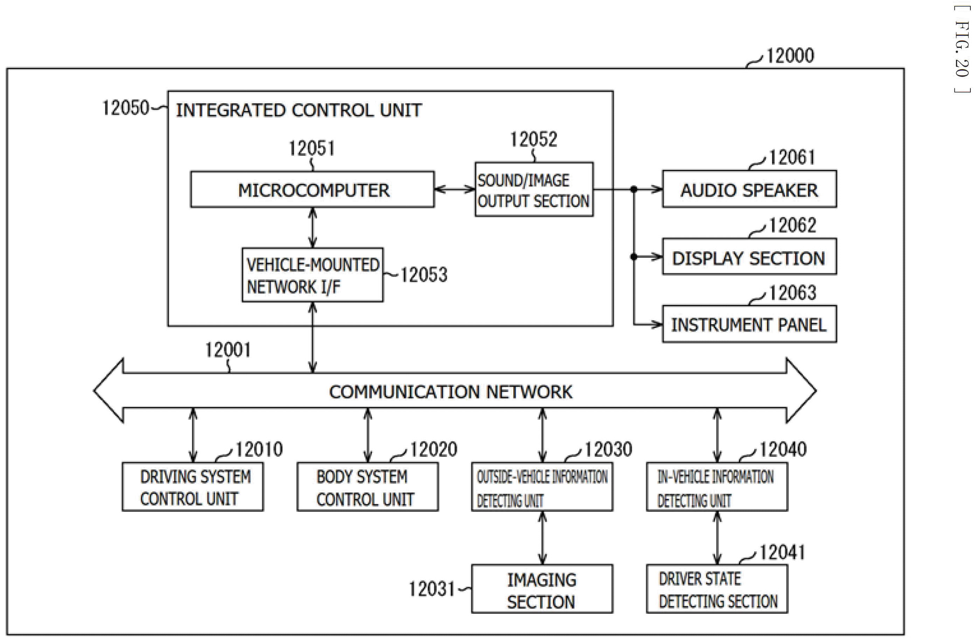

FIG. 20 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 20, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 1021, an audio speaker 12061, a display section 12062, and an instrument panel 12063 are illustrated as the output device. The display section 12062 may, for example, include at least one of an on-board display and a head-up display.

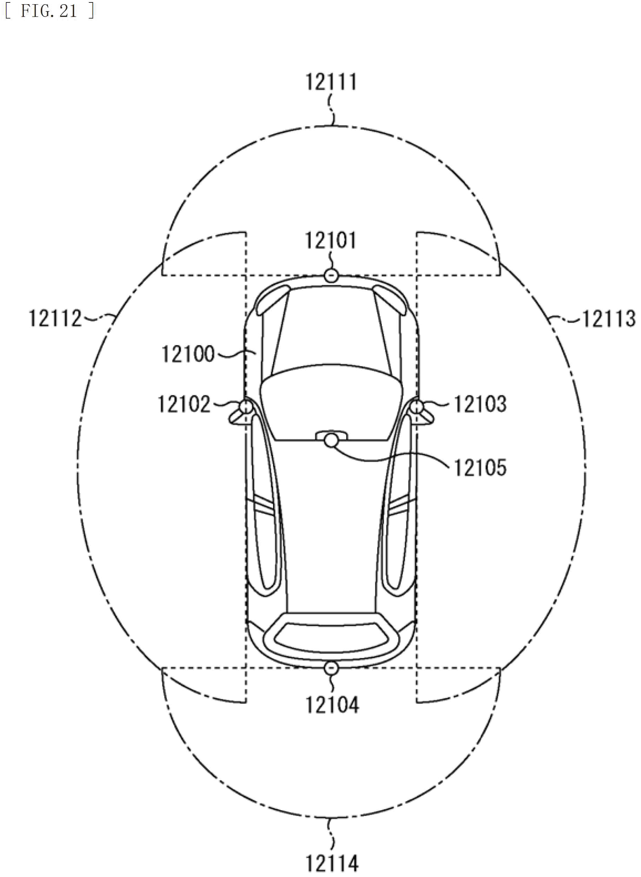

FIG. 21 is a diagram depicting an example of the installation position of the imaging section 12031.

In FIG. 21, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 21 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The example of the mobile body control system to which the technology according to the present disclosure is applicable has been described above. The technology according to the present disclosure is applicable to the imaging section 12031 out of the configurations described above, for example. Specifically, the light detecting device according to the first and second embodiments and the modification examples thereof (e.g., the imaging device 1) described above are applicable to the imaging section 12031. Applying the technology according to the present disclosure to the imaging section 12031 makes it possible to obtain a high-resolution captured image with less noises. It is therefore possible for the mobile body control system to perform high-resolution control based on the captured image.

Although the present disclosure has been described with reference to the first and second embodiments, the modification examples, the application examples, and the practical examples, the present technology is not limited to the embodiments and the like, and various modifications may be made.

It is to be noted that the effects described herein are mere examples and are not limited to those described, and other effects may also be made.

Further, the present disclosure may have the following configurations, for example. The semiconductor device having the following configurations makes it possible to have improved reliability by mitigating the electric field between the floating diffusion layer and the first transistor and to address miniaturization of pixels.
(1) A light detecting device including:
   a first semiconductor layer having a first surface and a second surface opposed to each other, the first semiconductor layer including a photoelectric converter buried in each pixel;
   a floating diffusion layer buried in the first surface of the first semiconductor layer, the floating diffusion layer having an upper surface flush with the first surface or protruding from the first surface, the floating diffusion layer accumulating signal charges generated at the photoelectric converter;
   a first transistor provided on the first surface of the first semiconductor layer, the first transistor reading the signal charges from the floating diffusion layer; and
   a first wiring including polysilicon, the first wiring being directly coupled to the upper surface of the floating diffusion layer.
(2) The light detecting device according to (1), in which the floating diffusion layer includes monocrystal silicon.
(3) The light detecting device according to (1) or (2), in which the first semiconductor layer further includes a lightly doped drain region between the floating diffusion layer and the first transistor on the first surface.
(4) The light detecting device according to (3), in which
   the floating diffusion layer, the lightly doped drain region, and the first wiring each include an impurity, and
   an impurity concentration gradient is formed in which a concentration of the impurity decreases in order of the first wiring, the floating diffusion layer, and the lightly doped drain region.
(5) The light detecting device according to (4), in which an impurity concentration gradient in which a concentration of the impurity gradually decreases from a portion coupling to the first wiring is formed in the floating diffusion layer.
(6) The light detecting device according to any one of (1) to (5), in which the first wiring extends in a substantially vertical direction with respect to the first surface of the first semiconductor layer.
(7) The light detecting device according to any one of (4) to (6), in which the impurity is phosphorus or arsenic.
(8) The light detecting device according to any one of (1) to (7), in which the floating diffusion layer is arranged at or near an intersection of four pixels arranged in two rows and two columns, and is shared among the four pixels.
(9) The light detecting device according to any one of (1) to (8), further including
   a pixel separation unit separating the pixels adjacent to each other, the pixel separation unit extending from the second surface toward the first surface of the first semiconductor layer, in which
   the pixel separation unit has a bottom surface inside the first semiconductor layer, and
   the floating diffusion layer is provided above the pixel separation unit.
(10) The light detecting device according to any one of (1) to (9), in which the floating diffusion layer is provided in each of the pixels and is formed in an active region of the first semiconductor layer.
(11) The light detecting device according to any one of (1) to (10), in which the first transistor includes a longitudinal gate electrode.
(12) The light detecting device according to any one of (1) to (11), further including
   a second semiconductor layer stacked on the first surface of the first semiconductor layer, in which
   the second semiconductor layer is provided with a pixel transistor that reads the signal charges from the floating diffusion layer via the first transistor.
(13) The light detecting device according to (12), further including
   a wiring layer between the first semiconductor layer and the second semiconductor layer, in which
   the wiring layer includes an interlayer insulating layer, a first wiring provided inside the interlayer insulating layer, and a second wiring coupled to the first wiring and extending in a substantially horizontal direction with respect to the first surface of the first semiconductor layer.
(14) The light detecting device according to (13), in which the second wiring includes a metal material including one or more of titanium, titanium nitride, and tungsten.
(15) The light detecting device according to any one of (6) to (14), in which
   the floating diffusion layer has a gap in an extending direction of the first wiring, and
   the first wiring is buried in the gap.
(16) The light detecting device according to (15), further including:
   a pixel separation unit separating the pixels adjacent to each other, the pixel separation unit extending from the second surface to the first surface of the first semiconductor layer, and having a bottom surface inside the first semiconductor layer; and
   an insulating film provided on the pixel separation unit, in which
   the floating diffusion layer is provided above the pixel separation unit via the insulating film, and
   the first wiring and the insulating film are buried in the gap.
(17) The light detecting device according to (16), in which the gap has a width narrower than a width of the insulating film.
(18) A solid-state imaging device including:
   an optical system;
   a light detecting device; and
   a signal processing circuit calculating a distance to a measurement target from an output signal of the light detecting device, in which
   the light detecting device includes:
      a first semiconductor layer having a first surface and a second surface opposed to each other, the first semiconductor layer including a photoelectric converter buried in each pixel;
      a floating diffusion layer buried in the first surface of the first semiconductor layer, the floating diffusion layer having an upper surface flush with the first surface or protruding from the first surface, the floating diffusion layer accumulating signal charges generated at the photoelectric converter;
      a first transistor provided on the first surface of the first semiconductor layer, the first transistor reading the signal charges from the floating diffusion layer; and
      a first wiring including polysilicon, the first wiring being directly coupled to the upper surface of the floating diffusion layer.
(19) A light detecting device including:
   a first semiconductor layer having a first surface and a second surface opposed to each other, the first semiconductor layer including a photoelectric converter buried in each pixel;
   a floating diffusion layer buried in the first surface of the first semiconductor layer, the floating diffusion layer accumulating signal charges generated at the photoelectric converter, the floating diffusion layer including monocrystal silicon;
   a first transistor provided on the first surface of the first semiconductor layer, the first transistor reading the signal charges from the floating diffusion layer;
   a lightly doped drain region provided between the floating diffusion layer and the first transistor on the first surface of the first semiconductor layer; and
   a wiring coupled to the floating diffusion layer and including polysilicon, in which
   the floating diffusion layer, the lightly doped drain region, and the wiring each include an impurity, and
   an impurity concentration gradient is formed in which a concentration of the impurity decreases in order of the wiring, the floating diffusion layer, and the lightly doped drain region.
(20) A light detecting device including:
   a first semiconductor layer having a first surface and a second surface opposed to each other, the first semiconductor layer including a photoelectric converter buried in each pixel;
   a floating diffusion layer provided on the first surface of the first semiconductor layer, the floating diffusion layer accumulating signal charges generated at the photoelectric converter;
   a first transistor provided on the first surface of the first semiconductor layer, the first transistor reading the signal charges from the floating diffusion layer; and
   a pixel circuit provided on the first surface of the first semiconductor layer, the pixel circuit reading the signal charges from the floating diffusion layer via the first transistor and outputting pixel signals, the pixel circuit including a second transistor, in which
   one or both of an upper surface of the floating diffusion layer and an upper surface of a source of the second transistor protrude from the first surface of the first semiconductor layer.
(21) The light detecting device according to (20), in which the second transistor is electrically coupled to the floating diffusion layer and has a same node as the floating diffusion layer.
(22) The light detecting device according to (20) or (21), in which
   the pixel circuit includes a reset transistor, an amplification transistor, and a selection transistor, and
   the second transistor is the reset transistor.
(23) The light detecting device according to (22), in which upper surfaces of sources and drains of the reset transistor, the amplification transistor, and the selection transistor protrude from the first surface of the first semiconductor layer.
(24) The light detecting device according to any one of (20) to (23), further including a first wiring directly coupled to the upper surface of the floating diffusion layer, in which
   only a portion of the floating diffusion layer coupling to the first wiring protrudes from the first surface of the first semiconductor layer.
(25) A solid-state imaging device including:
   an optical system;
   a light detecting device; and
   a signal processing circuit calculating a distance to a measurement target from an output signal of the light detecting device, in which
   the light detecting device includes:
      a first semiconductor layer having a first surface and a second surface opposed to each other, the first semiconductor layer including a photoelectric converter buried in each pixel;
      a floating diffusion layer provided on the first surface of the first semiconductor layer, the floating diffusion layer accumulating signal charges generated at the photoelectric converter;
      a first transistor provided on the first surface of the first semiconductor layer, the first transistor reading the signal charges from the floating diffusion layer; and
      a pixel circuit provided on the first surface of the first semiconductor layer, the pixel circuit reading the signal charges from the floating diffusion layer via the first transistor and outputting pixel signals, the pixel circuit including a second transistor, in which
   one or both of an upper surface of the floating diffusion layer and an upper surface of a source of the second transistor protrude from the first surface of the first semiconductor layer.

The present application claims the benefit of Japanese Priority Patent Application JP2023-180648 filed with the Japan Patent Office on October 19, 2023, the entire contents of which are incorporated herein by reference.

It should be understood by those skilled in the art that various modifications, combinations, subcombinations and alternations may occur depending on design requirements and other factors insofar as they are within the scope of the appended claims or the equivalents thereof.

## Claims

1. A light detecting device comprising:
a first semiconductor layer having a first surface and a second surface opposed to each other, the first semiconductor layer including a photoelectric converter buried in each pixel;
a floating diffusion layer buried in the first surface of the first semiconductor layer, the floating diffusion layer having an upper surface flush with the first surface or protruding from the first surface, the floating diffusion layer accumulating signal charges generated at the photoelectric converter;
a first transistor provided on the first surface of the first semiconductor layer, the first transistor reading the signal charges from the floating diffusion layer; and
a first wiring including polysilicon, the first wiring being directly coupled to the upper surface of the floating diffusion layer.

2. The light detecting device according to claim 1, wherein the floating diffusion layer includes monocrystal silicon.

3. The light detecting device according to claim 1, wherein the first semiconductor layer further includes a lightly doped drain region between the floating diffusion layer and the first transistor on the first surface.

4. The light detecting device according to claim 3, wherein
the floating diffusion layer, the lightly doped drain region, and the first wiring each include an impurity, and
an impurity concentration gradient is formed in which a concentration of the impurity decreases in order of the first wiring, the floating diffusion layer, and the lightly doped drain region.

5. The light detecting device according to claim 4, wherein an impurity concentration gradient in which a concentration of the impurity gradually decreases from a portion coupling to the first wiring is formed in the floating diffusion layer.

6. The light detecting device according to claim 1, wherein the first wiring extends in a substantially vertical direction with respect to the first surface of the first semiconductor layer.

7. The light detecting device according to claim 4, wherein the impurity is phosphorus or arsenic.

8. The light detecting device according to claim 1, wherein the floating diffusion layer is arranged at or near an intersection of four pixels arranged in two rows and two columns, and is shared among the four pixels.

9. The light detecting device according to claim 1, further comprising
a pixel separation unit separating the pixels adjacent to each other, the pixel separation unit extending from the second surface toward the first surface of the first semiconductor layer, wherein
the pixel separation unit has a bottom surface inside the first semiconductor layer, and
the floating diffusion layer is provided above the pixel separation unit.

10. The light detecting device according to claim 1, wherein the floating diffusion layer is provided in each of the pixels and is formed in an active region of the first semiconductor layer.

11. The light detecting device according to claim 1, wherein the first transistor includes a longitudinal gate electrode.

12. The light detecting device according to claim 1, further comprising
a second semiconductor layer stacked on the first surface of the first semiconductor layer, wherein
the second semiconductor layer is provided with a pixel transistor that reads the signal charges from the floating diffusion layer via the first transistor.

13. The light detecting device according to claim 12, further comprising
a wiring layer between the first semiconductor layer and the second semiconductor layer, wherein
the wiring layer includes an interlayer insulating layer, the first wiring provided inside the interlayer insulating layer, and a second wiring coupled to the first wiring and extending in a substantially horizontal direction with respect to the first surface of the first semiconductor layer.

14. The light detecting device according to claim 13, wherein the second wiring includes a metal material including one or more of titanium, titanium nitride, and tungsten.

15. The light detecting device according to claim 6, wherein
the floating diffusion layer has a gap in an extending direction of the first wiring, and
the first wiring is buried in the gap.

16. The light detecting device according to claim 15, further comprising:
a pixel separation unit separating the pixels adjacent to each other, the pixel separation unit extending from the second surface toward the first surface of the first semiconductor layer, and having a bottom surface inside the first semiconductor layer; and
an insulating film provided on the pixel separation unit, wherein
the floating diffusion layer is provided above the pixel separation unit via the insulating film, and
the first wiring and the insulating film are buried in the gap.

17. The light detecting device according to claim 16, wherein the gap has a width narrower than a width of the insulating film.

18. A solid-state imaging device comprising:
an optical system;
a light detecting device; and
a signal processing circuit calculating a distance to a measurement target from an output signal of the light detecting device, wherein
the light detecting device includes:
a first semiconductor layer having a first surface and a second surface opposed to each other, the first semiconductor layer including a photoelectric converter buried in each pixel;
a floating diffusion layer buried in the first surface of the first semiconductor layer, the floating diffusion layer having an upper surface flush with the first surface or protruding from the first surface, the floating diffusion layer accumulating signal charges generated at the photoelectric converter;
a first transistor provided on the first surface of the first semiconductor layer, the first transistor reading the signal charges from the floating diffusion layer; and
a first wiring including polysilicon, the first wiring being directly coupled to the upper surface of the floating diffusion layer.
